# EUROPEAN PATENT SPECIFICATION

(11) **EP 3 341 430 B1**
(45) Date of publication and mention of the grant of the patent: **02.01.2019**
(21) Application number: 17727382.8
(22) Date of filing: 28.04.2017
(51) Int. Cl.: C08G 64/12, C08L 69/00

(54) **PHTHALIMIDINE COPOLYCARBONATES, ARTICLES FORMED THEREFROM, AND METHODS OF MANUFACTURE**
PHTHALIMIDIN-COPOLYCARBONATE, DARAUS GEFORMTE ARTIKEL UND VERFAHREN ZUR HERSTELLUNG
COPOLYCARBONATES DE PHTALIMIDINE, ARTICLES FORMÉS À PARTIR DE CES DERNIERS, ET LEURS PROCÉDÉS DE FABRICATION

(30) Priority: 28.04.2016 US 201662328847 P
(43) Date of publication of application: 04.07.2018
(73) Proprietor: SABIC Global Technologies B.V., 4612 PX Bergen op Zoom (NL)
(72) Inventor: SYBERT, Paul Dean, Mount Vernon Indiana 47620 (US); FARRELL, Tony, 4612 PX Bergen op Zoom (NL); BOONMAN, Rob, 4612 PX Bergen op Zoom (NL); VAN DE GRAMPEL, Robert Dirk, 4612 PX Bergen op Zoom (NL); VAN DER MEE, Mark Adrianus Johannes, 4612 PX Bergen op Zoom (NL)
(74) Representative: Modiano, Micaela Nadia
(86) International application number: PCT/IB2017/052503
(87) International publication number: WO 2017/187425

(56) References cited:
- WO-A1-2015/160965

## Description

### BACKGROUND

This disclosure is directed to copolycarbonates, thermoplastic compositions including the copolycarbonates, articles formed therefrom, and their methods of manufacture, and in particular high flow, high heat copolycarbonates, and compositions and articles formed therefrom.

Polycarbonates are useful in the manufacture of articles and components for a wide range of applications, from automotive parts to electronic appliances. Because of their broad use, particularly in automotive, lighting and consumer electronics industries, it is desirable to provide polycarbonates having high heat capacities and good surface properties such as the ability to be metalized.

It is particularly challenging to develop materials that meet these often conflicting requirements and simultaneously have good mechanical properties and processability. Accordingly, there remains a need for polycarbonates that have a combination of improved thermal performance such as high heat deflection temperature and good surface properties such as good adhesion to metal without a significant detrimental effect on one or more of material cost, processability, and mechanical properties. It would be a further advantage if the polycarbonates had high flow so that they could be readily thermoformed or injection molded. It would be a still further advantage if the polycarbonates had low color and good hydrolytic stability.
WO 2015/160965 discloses a polycarbonate blend compositions including at least one polycarbonate useful for high heat applications. The compositions can include one or more additional polymers and one or more additives and can be used to prepare articles of manufacture, and in particular, automotive bezels.

### SUMMARY

A copolycarbonate comprises first repeating units, second repeating units different from the first repeating units, and third repeating units different from the first and second repeating units; and wherein the first repeating units are phthalimidine carbonate units of the formula 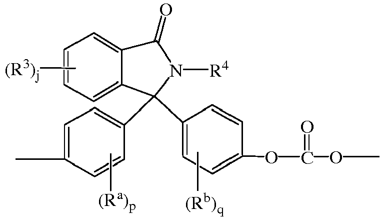 wherein R^{a} and R^{b} are each independently a C₁₋₁₂ alkyl, C₂₋₁₂ alkenyl, C₃₋₈ cycloalkyl, or C₁₋₁₂ alkoxy, each R³ is independently a C₁₋₆ alkyl, R⁴ is hydrogen, C₂₋₆ alkyl or phenyl optionally substituted with 1 to 5 C₁₋₆ alkyl groups, p, q, and j are each independently 0 to 4, the second repeating units are carbonate units of the formula 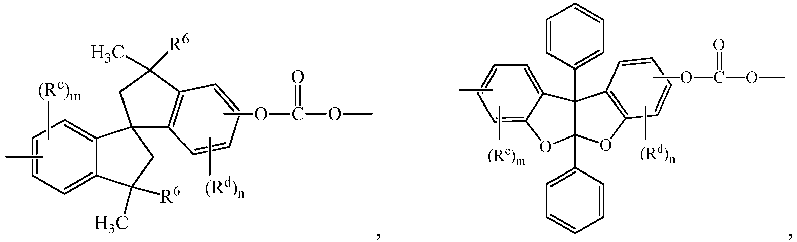 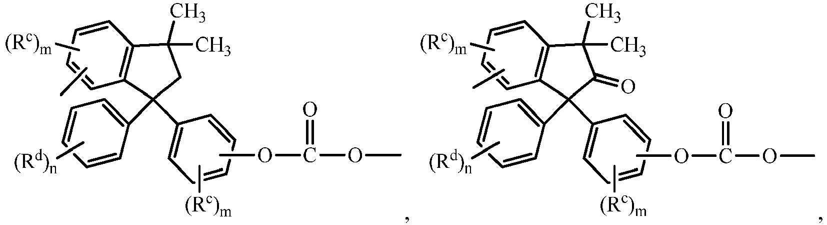 or 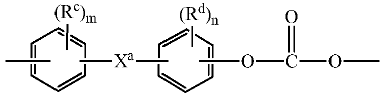 wherein R^{c} and R^{d} are each independently a C₁₋₁₂ alkyl, C₂₋₁₂ alkenyl, C₃₋₈ cycloalkyl, or C₁₋₁₂ alkoxy, each R⁶ is independently C₁₋₃ alkyl or phenyl; X^{a} is a C₆₋₁₂ polycyclic aryl, C₃₋₁₈ mono- or polycycloalkylene, C₃₋₁₈ mono- or polycycloalkylidene, -(Q¹)ₓ-G-(Q²)_{y}- group wherein Q¹ and Q² are each independently a C₁₋₃ alkylene, G is a C₃₋₁₀ cycloalkylene, x is 0 or 1, and y is 1; and m and n are each independently 0 to 4; and the third repeating units are carbonate units of the formula 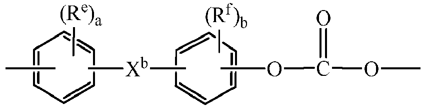 wherein R^{e} and R^{f} are each independently C₁₋₁₂ alkyl, C₂₋₁₂ alkenyl, C₃₋₈ cycloalkyl, or C₁₋₁₂ alkoxy, a and b are each independently integers of 0 to 4, and X^{b} is a single bond, -O-, -S-, - S(O)-, -S(O)₂-, -C(O)-, or C₁₋₃₂ bridging hydrocarbon group, provided that X^{b} is not a phthalimidine group or X^{a}.

In another embodiment, disclosed is a thermoplastic composition comprising the copolycarbonate.

In yet another embodiment, an article comprises the above-described copolycarbonate or thermoplastic composition.

A metallized article comprising the above-described copolycarbonate or the composition, wherein the defect onset temperature of the metallized article is within 20 degrees Celsius of the heat deflection temperature of the copolycarbonate or the composition measured flat on a 80 x 10 x 4 mm bar with a 64 mm span at 0.45 MPa according to ISO 75/Bf.

In another embodiment, a metallized article comprises a substrate comprising the above-described copolycarbonate or the composition and a metal layer disposed on at least one side of the substrate.

In still another embodiment, a method of manufacture of an article comprises molding, extruding, or shaping the above-described copolycarbonate or thermoplastic composition into an article.

The above described and other features are exemplified by the following drawings, detailed description, examples, and claims.

### BRIEF DESCRIPTION OF THE DRAWINGS

A description of the figures, which are meant to be exemplary and not limiting, is provided in which:
FIG. 1 shows Mw loss after heat aging in solution in the presence of water at 75°C for 120 hours as a function of mol% of PPPBP units in the composition;
FIG. 2 shows the chloride level in the polymer phase after decantation as a function of the mol% of PPPBP units in the composition; and
FIG. 3 shows defect onset temperature as a function of mol% of PPPBP units in the composition.

### DETAILED DESCRIPTION

The inventors hereof have found that phthalimidine copolycarbonates comprising phthalimidine carbonate units, carbonate units derived from a bisphenol such as 1,1-bis(4-hydroyphenyl)-3,3,5-trimethyl-cyclohexane, and carbonate units derived from another bisphenol such as bisphenol A have high heat resistance and improved adhesion to metal compared to copolycarbonates consisting of bisphenol A carbonate units and 1,1-bis(4-hydroyphenyl)-3,3,5-trimethyl-cyclohexane carbonate units. In addition, the phthalimidine copolycarbonates have improved hydrolytic stability compared to copolycarbonates consisting of bisphenol A carbonate units and phthalimidine carbonate units, which allows the phthalimidine copolycarbonates to be used in high humidity applications. Moreover, the phthalimidine copolycarbonates can be readily manufactured as it has improved separation time of aqueous phases from the polymer solutions during water washes in the manufacturing process whereas the copolycarbonates consisting of bisphenol A carbonate units and phthalimidine carbonate units suffer from the propensity to form emulsions during polymer purification steps. As a further advantageous feature, the phthalimidine copolycarbonates can have low color. The phthalimidine copolycarbonates can also have high melt flow rate.

As used herein, the phthalimidine copolycarbonates have first, second, and third repeating units, wherein the first repeating units are phthalimidine carbonate units, the second repeating units are bisphenol carbonate units different from the first repeating units, and the third repeating units are bisphenol carbonate units different from the first and second repeating units.

The first repeating units are phthalimidine carbonate units of formula (1) 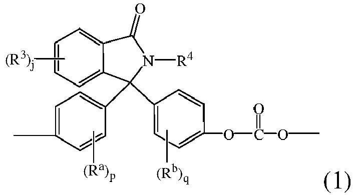 wherein R^{a} and R^{b} are each independently a C₁₋₁₂ alkyl, C₂₋₁₂ alkenyl, C₃₋₈ cycloalkyl, or C₁₋₁₂ alkoxy, preferably a C₁₋₃ alkyl, each R³ is independently a C₁₋₆ alkyl, R⁴ is hydrogen, C₂₋₆ alkyl or phenyl optionally substituted with 1 to 5 C₁₋₆ alkyl groups, and p, q, and j are each independently 0 to 4, preferably 0 to 1. For example, the phthalimidine carbonate units can be of formula (1a) 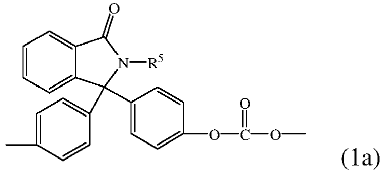 wherein R⁵ is hydrogen, phenyl optionally substituted with up to five C₁₋₆ alkyl groups, or C₁₋₄ alkyl, preferably C₂₋₄ alkyl. In an embodiment, R⁵ is hydrogen or phenyl. Carbonate units (1a) wherein R⁵ is phenyl can be derived from 2-phenyl-3,3'-bis(4-hydroxy phenyl)phthalimidine (also known as 3,3-bis(4-hydroxyphenyl)-2-phenylisoindolin-1-one or N-phenyl phenolphthalein or "PPPBP").

The second repeating units are carbonate units of the formula (2), (3), (4), (16), or (17) 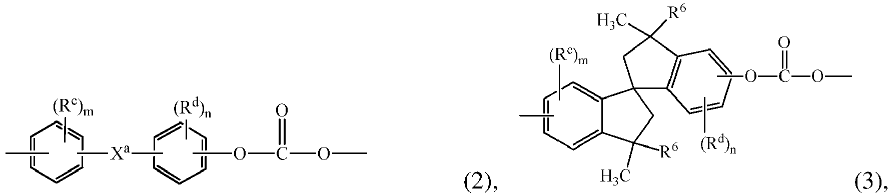 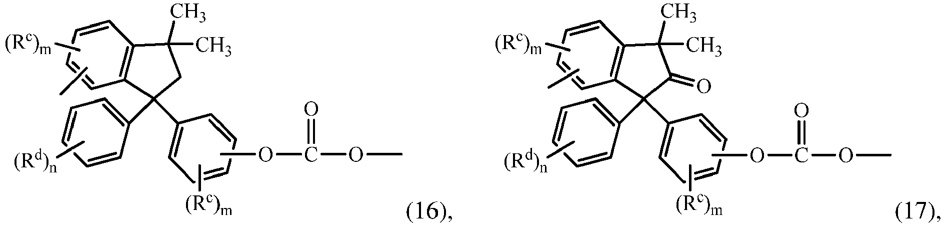 or 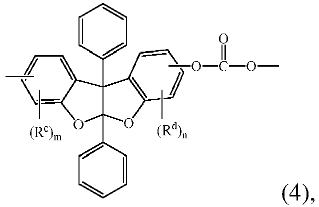 wherein R^{c} and R^{d} are each independently a C₁₋₁₂ alkyl, C₁₋₁₂ alkenyl, C₃₋₈ cycloalkyl, or C₁₋₁₂ alkoxy, each R⁶ is independently C₁₋₃ alkyl or phenyl, preferably methyl, X^{a} is a C₆₋₁₂ polycyclic aryl, C₃₋₁₈ mono- or polycycloalkylene, C₃₋₁₈ mono- or polycycloalkylidene, - (Q¹)ₓ-G-(Q²)_{y}- group wherein Q¹ and Q² are each independently a C₁₋₃ alkylene, G is a C₃₋₁₀ cycloalkylene, x is 0 or 1, and y is 1; and m and n are each independently 0 to 4.

Exemplary second repeating units include the following: 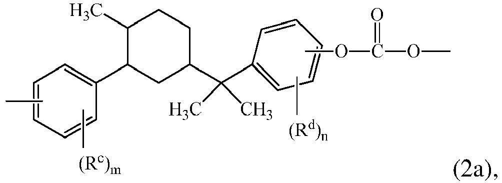 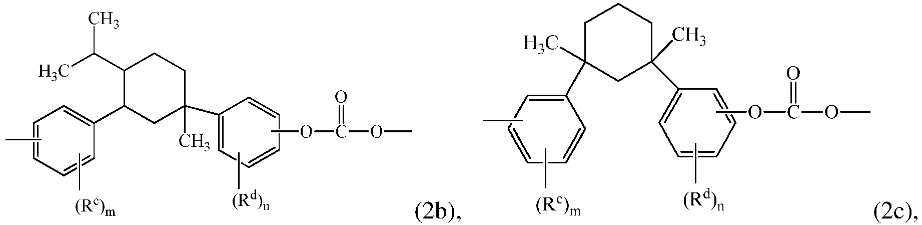 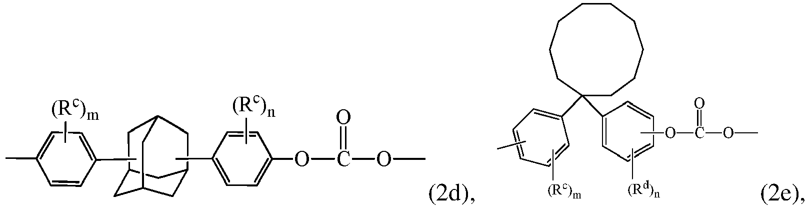 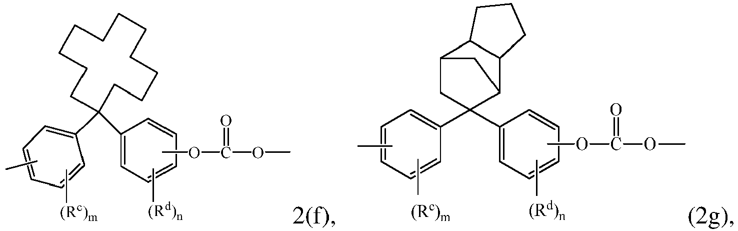 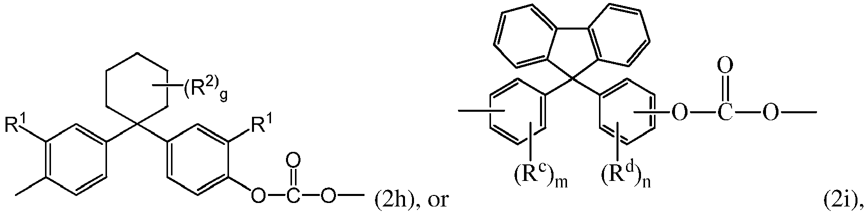 wherein R^{c}, R^{d}, m, and n are the same as defined herein for formulas (2)-(4), (16), and (17), each R¹ is independently hydrogen or C₁₋₄ alkyl, each R² is independently C₁₋₄ alkyl, and g is 0 to 10. In a specific embodiment the second carbonate units are 1,1-bis(4-hydroyphenyl)-3,3,5-trimethyl-cyclohexane carbonate units, 1,1-bis(4-hydroxy-3-methylphenyl)cyclohexane, or a combination thereof. Preferably, the second repeating units are 1,1-bis(4-hydroyphenyl)-3,3,5-trimethyl-cyclohexane (BPA TMC) carbonate units.

The third repeating units are bisphenol carbonate units of formula (5) 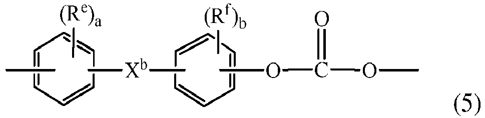 wherein R^{e} and R^{f} are each independently C₁₋₁₂ alkyl, C₂₋₁₂ alkenyl, C₃₋₈ cycloalkyl, or C₁₋₁₂ alkoxy, a and b are each independently 0 to 4, and X^{b} is a bridging group between the two arylene groups, and is a single bond, -O-, -S-, -S(O)-, -S(O)₂-, -C(O)-, or a C₁₋₃₂ bridging hydrocarbon group, provided that X^{b} is not a phthalimidine group or X^{a}. In an embodiment, X^{b} is a C₁₋₁₁ alkylidene of the formula -C(R^{c})(R^{d}) - wherein R^{c} and R^{d} are each independently hydrogen or C₁₋₁₀ alkyl, or a group of the formula -C(=R^{e})- wherein R^{e} is a divalent C₁₋₁₀ hydrocarbon group. Exemplary X^{b} groups include methylene, ethylidene, neopentylidene, and isopropylidene. The bridging group X^{b} and the carbonate oxygen atoms of each C₆ arylene group can be disposed ortho, meta, or para (preferably para) to each other on the C₆ arylene group.

In a specific embodiment, R^{e} and R^{f} are each independently a C₁₋₃ alkyl group, a and b are each independently 0 to 1, and X^{b} is a single bond, -O-, -S(O)-, -S(O)₂-, -C(O)-, a C₁₋₉ alkylidene of formula -C(R^{c})(R^{d})- wherein R^{c} and R^{d} are each independently hydrogen or C₁₋₈ alkyl, or a group of the formula -C(=R^{e})- wherein R^{e} is a divalent C₁₋₉ hydrocarbon group. In another specific embodiment, R^{e} and R^{f} are each independently a methyl group, a and b are each independently 0 to 1, and X^{b} is a single bond, a C₁₋₇ alkylidene of formula - C(R^{c})(R^{d}) - wherein R^{c} and R^{d} are each independently hydrogen or C₁₋₆ alkyl. In an embodiment, a and b is each 1, and R^{e} and R^{f} are each a C₁₋₃ alkyl group, preferably methyl, disposed meta to the oxygen on each ring. The bisphenol carbonate units (5) can be derived from bisphenol A, where a and b are both 0 and X^{b} is isopropylidene.

The copolycarbonate comprises 5 mol% to 30 mol% of the first repeating units, 2 mol% to 50 mol% of the second repeating units, and 45 mol% to 70 mol% of the third repeating units, each based on the sum of moles of the first repeating units, second repeating units, and third repeating units. In specific embodiments, the copolycarbonate comprises 3 mol% to 28 mol% of the first repeating units, 4 mol% to 20 mol% of the second repeating units, and 50 mol% to 65 mol% of the third repeating units, each based on the sum of the moles of the first repeating units, second repeating units, and third repeating units.

Other carbonate units can be present in any of the phthalimidine copolycarbonates described herein in relatively small amounts, for example less than 20 mole%, less than 10 mole%, or less than 5 mole%, based on the total moles of units in the phthalimidine copolycarbonate. In an embodiment, no other carbonate units are present. In still another embodiment, no other types of repeating units are present in the copolycarbonates, for example no ester units.

The phthalimidine copolycarbonates can have a weight average molecular weight of 10,000 to 50,000 Daltons, preferably 18,000 to 25,000 Daltons, as measured by gel permeation chromatography (GPC), using a crosslinked styrene-divinylbenzene column and calibrated to bisphenol A homopolycarbonate references. GPC samples are prepared at a concentration of 1 mg per ml, and are eluted at a flow rate of 1.5 ml per minute.

In an embodiment, the phthalimidine copolycarbonate has flow properties useful for the manufacture of thin articles. Melt volume flow rate (often abbreviated MVR) measures the rate of extrusion of a thermoplastic through an orifice at a prescribed temperature and load. Phthalimidine copolycarbonates useful for the formation of thin articles can have an MVR of 10 to 30 cm³/10 minutes, preferably 15 to 25 cm³/10 minutes, measured at 330°C under a load of 2.16 kg in accordance with ASTM D1238-04.

The phthalimidine copolycarbonates have a high glass transition temperature (Tg). The Tg of the phthalimidine copolycarbonates is 195 to 205 °C, preferably 196 to 204 °C, determined by differential scanning calorimetry (DSC) as per ASTM D3418 with a 20°C/min heating rate.

The phthalimidine copolycarbonates can have high heat resistance. The heat deflection temperature (HDT) of the phthalimidine copolycarbonates is 175 to 225 °C, preferably 181 to 186°C, measured flat on a 80 x 10 x 4 mm bar with a 64 mm span at 0.45 MPa according to ISO 75/Bf.

The phthalimidine copolycarbonates can have high Vicat softening temperature. In an embodiment, the phthalimidine copolycarbonates have a Vicat B120 of 175 to 225 °C, preferably 185 to 195 °C, measured according to ISO 306.

The phthalimidine copolycarbonates can have excellent metallization properties. In an embodiment, a metalized sample of the phthalimidine copolycarbonate has a defect onset temperature that is within 20 degrees Celsius of the heat deflection temperature of the copolycarbonate where the HDT is measured flat on a 80 x 10 x 4 mm bar with a 64 mm span at 0.45 MPa according to ISO 75/Bf. In another embodiment, a metalized sample of the phthalimidine copolycarbonate has a defect onset temperature that is within 10 degrees Celsius of the heat deflection temperature of the copolycarbonate where the HDT is measured flat on a 80 x 10 x 4 mm bar with a 64 mm span at 0.45 MPa according to ISO 75/Bf.

The phthalimidine copolycarbonates can have improved hydrolytic stability as compared to copolycarbonates comprising the first and third repeating units but not the second repeating units. In an embodiment, the phthalimidine copolycarbonates have less than 10% or less than 8% molecular weight loss (Mw loss) after aging in solution in the presence of water at 75°C for 120 hours.

The phthalimidine copolycarbonates can have a visual transmission (Tvis) of 80% to 90% measured on HAZE-GUARD plus from BYK-Gardner instruments.

The phthalimidine copolycarbonates can further have a Notched Izod Impact of 5 to 10 KJ/m², determined in accordance with ISO 180 under a load of 5.5 J at 23°C on a sample of 3 mm thickness.

Polycarbonates can be manufactured by processes such as interfacial polymerization and melt polymerization, which are known, and are described, for example, in WO 2013/175448 A1 and WO 2014/072923 A1 using the corresponding bisphenols of the first, second, and third repeating units. The first repeating units can be derived from a bisphenol of the formula 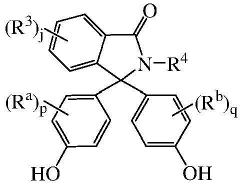 wherein R³, R⁴, R^{a}, R^{b}, p, q, and j are the same as defined herein for formula (1).

The second repeating units can be derived from a bisphenol of the following formula: 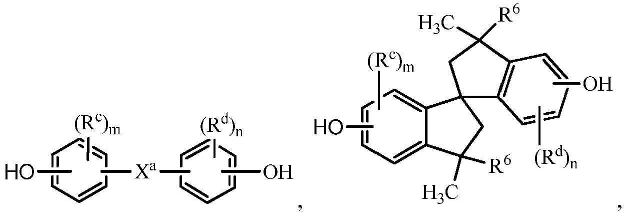 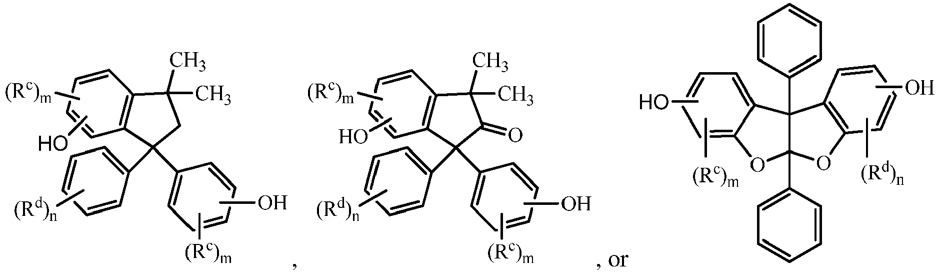 wherein R^{c}, R^{d}, R⁶, m, and n are the same as defined herein for formulas (2)-(4), (16), and (17).

The third repeating units can be derived from a bisphenol of the formula 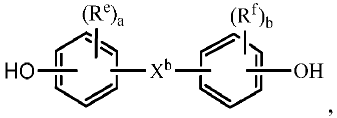 wherein R^{e}, R^{f}, and X^{b} are the same as defined herein for formula (5).

An end-capping agent (also referred to as a chain stopper agent or chain terminating agent) can be included during polymerization to provide end groups, for example monocyclic phenols such as phenol, p-cyanophenol, and C₁-C₂₂ alkyl-substituted phenols such as p-cumyl-phenol, resorcinol monobenzoate, and p-and tertiary-butyl phenol, monoethers of diphenols, such as p-methoxyphenol, monoesters of diphenols such as resorcinol monobenzoate, functionalized chlorides of aliphatic monocarboxylic acids such as acryloyl chloride and methacryoyl chloride, and mono-chloroformates such as phenyl chloroformate, alkyl-substituted phenyl chloroformates, p-cumyl phenyl chloroformate, and toluene chloroformate. Combinations of different end groups can be used. Branched polycarbonate blocks can be prepared by adding a branching agent during polymerization, for example trimellitic acid, trimellitic anhydride, trimellitic trichloride, tris-p-hydroxyphenylethane, isatin-bis-phenol, tris-phenol TC (1,3,5-tris((p-hydroxyphenyl)isopropyl)benzene), tris-phenol PA (4(4(1,1-bis(p-hydroxyphenyl)-ethyl) alpha, alpha-dimethyl benzyl)phenol), 4-chloroformyl phthalic anhydride, trimesic acid, and benzophenone tetracarboxylic acid. The branching agents can be added at a level of 0.05 to 2.0 wt. %. Combinations comprising linear polycarbonates and branched polycarbonates can be used.

Also disclosed are thermoplastic compositions comprising the phthalimidine copolycarbonate. In addition to the phthalimidine copolycarbonate, the thermoplastic compositions can further comprise a polycarbonate homopolymer such as a bisphenol A homopolycarbonate, a poly(ester-carbonate), a second copolycarbonate that is different from the phthalimidine copolycarbonate, or a combination comprising at least one of the foregoing. The phthalimidine copolycarbonate can be present in an amount of 40 wt. % to 70 wt. % and the polycarbonate homopolymer, the poly(ester-carbonate), the copolycarbonate different from the phthalimidine copolycarbonate or a combination thereof can be present in an amount of 30 wt.% to 60 wt.%, each based on the total weight of the thermoplastic composition.

Poly(ester-carbonate)s further contain, in addition to recurring carbonate chain units derived from a dihydroxy compound, repeating ester units of formula (6) 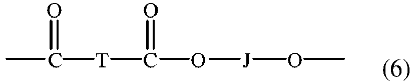 wherein J is a divalent group derived from a dihydroxy compound (which includes a reactive derivative thereof), and can be, for example, a C₂₋₁₀ alkylene, a C₆₋₂₀ cycloalkylene a C₆₋₂₀ arylene, or a polyoxyalkylene group in which the alkylene groups contain 2 to 6 carbon atoms, preferably, 2, 3, or 4 carbon atoms; and T is a divalent group derived from a dicarboxylic acid (which includes a reactive derivative thereof), and can be, for example, a C₂₋₂₀ alkylene, a C₆₋₂₀ cycloalkylene, or a C₆₋₂₀ arylene. Copolyesters containing a combination of different T or J groups can be used. The polyester units can be branched or linear.

Specific dihydroxy compounds include resorcinol, bisphenols used to make the carbonate units of formulas (1)-(5), (16), or (17), a C₁₋₈ aliphatic diol such as ethane diol, n-propane diol, i-propane diol, 1,4-butane diol, 1,6-cyclohexane diol, 1,6-hydroxymethylcyclohexane, or a combination comprising at least one of the foregoing dihydroxy compounds. Aliphatic dicarboxylic acids that can be used include C₆₋₂₀ aliphatic dicarboxylic acids (which includes the terminal carboxyl groups), preferably linear C₈₋₁₂ aliphatic dicarboxylic acid such as decanedioic acid (sebacic acid); and alpha, omega-C₁₂ dicarboxylic acids such as dodecanedioic acid (DDDA). Aromatic dicarboxylic acids that can be used include terephthalic acid, isophthalic acid, naphthalene dicarboxylic acid, 1,6-cyclohexane dicarboxylic acid, or a combination comprising at least one of the foregoing acids. A combination of isophthalic acid and terephthalic acid wherein the weight ratio of isophthalic acid to terephthalic acid is 91:9 to 2:98 can be used.

Specific ester units include ethylene terephthalate units, n-proplyene terephthalate units, n-butylene terephthalate units, ester units derived from isophthalic acid, terephthalic acid, and resorcinol (ITR ester units), and ester units derived from sebacic acid and bisphenol A. The molar ratio of ester units to carbonate units in the poly(ester-carbonate)s can vary broadly, for example 1:99 to 99:1, preferably, 10:90 to 90:10, more preferably, 25:75 to 75:25, or from 2:98 to 15:85. In some embodiments the molar ratio of ester units to carbonate units in the poly(ester-carbonate)s can vary from 1:99 to 30: 70, preferably 2:98 to 25:75, more preferably 3:97 to 20:80, or from 5:95 to 15:85.

The thermoplastic compositions can include various additives ordinarily incorporated into polymer compositions of this type, with the proviso that the additive(s) are selected so as to not significantly adversely affect the desired properties of the thermoplastic composition, in particular melt flow, thermal, and surface properties. Such additives can be mixed at a suitable time during the mixing of the components for forming the composition. Additives include fillers, reinforcing agents, antioxidants, heat stabilizers, light stabilizers, ultraviolet (UV) light stabilizers, plasticizers, lubricants, mold release agents, antistatic agents, colorants such as such as titanium dioxide, carbon black, and organic dyes, surface effect additives, radiation stabilizers, flame retardants, and anti-drip agents. A combination of additives can be used, for example a combination of a heat stabilizer, mold release agent, and ultraviolet light stabilizer. In general, the additives are used in the amounts generally known to be effective. For example, the total amount of the additives (other than any impact modifier, filler, or reinforcing agents) can be 0.01 to 5 wt.%, based on the total weight of the thermoplastic composition. The thermoplastic compositions can be manufactured by various methods known in the art. For example, powdered polycarbonate, and other optional components are first blended, optionally with any fillers, in a high speed mixer or by hand mixing. The blend is then fed into the throat of a twin-screw extruder via a hopper. Alternatively, at least one of the components can be incorporated into the composition by feeding it directly into the extruder at the throat or downstream through a sidestuffer, or by being compounded into a masterbatch with a desired polymer and fed into the extruder. The extruder is generally operated at a temperature higher than that necessary to cause the composition to flow. The extrudate can be immediately quenched in a water bath and pelletized. The pellets so prepared can be one-fourth inch long or less as desired. Such pellets can be used for subsequent molding, shaping, or forming.

The thermoplastic composition can have an MVR of 5 to 30, preferably 10 to 30, more preferably 18 to 28 cm³/10 minutes, measured at 330°C under a load of 2.16 kg in accordance with ASTM D1238-04.

The thermoplastic composition can have a heat deflection temperature (HDT) of 160 to 165 °C, measured flat on a 80 x 10 x 4 mm bar with a 64 mm span at 0.45 MPa according to ISO 75/Bf.

The thermoplastic composition can have excellent metallization properties. In an embodiment, a metalized sample of the thermoplastic composition has a defect onset temperature that is within 20 degrees Celsius, preferably within 10 degrees Celsius of the heat deflection temperature of the copolycarbonate where the HDT is measured flat on a 80 x 10 x 4 mm bar with a 64 mm span at 0.45 MPa according to ISO 75/Bf.

Shaped, formed, or molded articles comprising the phthalimidine copolycarbonates or the thermoplastic compositions are also provided. The copolymers and compositions can be molded into useful shaped articles by a variety of methods, such as injection molding, extrusion, rotational molding, blow molding and thermoforming. Some example of articles include computer and business machine housings such as housings for monitors, handheld electronic device housings such as housings for cell phones, electrical connectors, and components of lighting fixtures, ornaments, home appliances, roofs, greenhouses, sun rooms, swimming pool enclosures, and the like. Additional exemplary articles include a plug, a plug housing, a switch, an electrical conductor, a connector, an electric board, a lamp holder, a lamp cover, a lamp bezel, a reflector, a signal indicator, glazing, a lens, a lens holder, a waveguide element, a collimator, a light emitting diode, a diffuser sheet, a safety pane, a film, a film laminate, a safety goggle, and a visor.

The article comprising the phthalimidine copolymers or the thermoplastic compositions can be a metallized article. The metallized article comprises, for example, a substrate comprising the phthalimidine copolymers, the polycarbonate blends, or thermoplastic compositions, with a metal layer disposed on the at least one side of the substrate.

The substrate can be for example, a film. The substrate can be made by molding the phthalimidine copolycarbonates or the thermoplastic compositions. The molding methods are not particularly limited, and various known molding methods can be listed, for example, injection molding, gas assist injection molding, vacuum molding, extrusion, compression molding, calendaring, rotary molding, etc. Of these, molding is usually carried out by injection molding.

The metal layer can be disposed onto the surface of the substrate with the aid of electrocoating deposition, physical vapor deposition, or chemical vapor deposition or a suitable combination of these methods. Sputtering processes can also be used. The metal layer resulting from the metallizing process (e.g., by vapor deposition) can be 0.001 to 50 micrometers (µm) thick.

A base coat can be present between the substrate and the metal layer. However, it is advantageous to form the metal layer directly on the substrate surface without forming an undercoat. The surfaces of the substrate are smooth and good gloss can be obtained even by direct metal vapor deposition without treating the substrate with primer. Moreover, the release properties of the molded substrate during injection molding are good. Accordingly, the surface properties of the molded substrate are superior without replication of mold unevenness.

Chrome, nickel, aluminum, etc. can be listed as examples of vaporizing metals. Aluminum vapor deposition is used in one embodiment as metal vapor deposition. The surface of the molded substrate can be treated with plasma, cleaned or degreased before vapor deposition in order to increase adhesion.

The metallized article can have a protective layer disposed on the metal layer. "Protective layer" refers for example, to a layer which is made of a binder or a high molecular weight polymer and formed on the outermost (e.g., the UV blocking) layer, so as to exert the effects of preventing marring and improving mechanical properties of the multilayer article. The protective layer can be clear or pigmented and be formulated, for example, with nitrocellulose or synthetic polymers configured to quickly dry by evaporation without chemical reaction with the layer on which they are disposed, providing a solid protective layer. The protective coating material can further be thinned with alcohols. In certain applications, the thickness of the protective layer is minimized. The thickness of the protective layer can be, for example, 0.2 µm or less.

The metallized articles can have little mold shrinkage, have good surface gloss even when metal layers are directly vapor deposited, and the vapor deposited surfaces do not become cloudy or have rainbow patterns even on heating of the vapor deposited surface. In particular, the metallized article can have no surface defects visible to the eye.

Illustratively, the metallized article has a metallized surface, wherein the surface can exhibit a gloss of greater than 95 units, or greater than 1700 units, measured at 20 degrees using a trigloss meter. The metallized surface can also retain 85%, 88%, 90%, 95% or more of its gloss after heat aging at 150°C for 1 hour, measured at 20 degrees using a micro trigloss meter. A base coat (undercoat) can be present between the article and the metallized surface, or a surface of the article can be directly metallized.

Metallized articles have applications in optical reflectors and can be used for automotive headlamps, headlight extensions and headlamp reflectors, for indoor illumination, for vehicle interior illumination and for the like.

### EXAMPLES

The polymers used in the Examples are described in Table 1A.

**Table 1A.**

| Component | Chemical Description (mol%) | Mw | Tg (°C) | Source |
|---|---|---|---|---|
| TerPC1 | 5-30-65 BPI-PPP-BPA | 22,600 +/-500 | 199 | SABIC |
| TerPC2 | 15-25-60 BPI-PPP-BPA | 22,600 +/-500 | 200 | SABIC |
| TerPC3 | 29.5-16.5-54 BPI-PPP-BPA | 22,600 +/-500 | 200 | SABIC |
| TerPC4 | 44-8-48 BPI-PPP-BPA | 22,600 +/-500 | 201 | SABIC |
| BPI-CoPC | 57-0-43 BPI-PPP-BPA | 22,600 +/-500 | 200 | SABIC |
| PPPBP-CoPC | 0-33-67 BPI-PPP-BPA | 22,600 +/-500 | 195 | SABIC |
| PC1 | 0-0-100 BPI-PPP-BPA | 18800 +/-500 | 143 | SABIC |

In Table 1A, BPI refers to 1,1-bis-(4-hydroxyphenyl)-3,3,5-trimethylcyclohexane carbonate units, PPPBP refers to N-phenyl phenolphthalein bisphenol carbonate units, and BPA refers to bisphenol A carbonate units.

The additives used in the Examples are described in Table 1B.

| | | |
|---|---|---|
| Hindered phenol | Octadecyl-3-(3,5-di-tert-butyl-4-hydroxyphenyl) propionate | BASF |
| Phosphite stabilizer | Tris(di-t-butylphenyl)phosphite | BASF |
| Mold release agent | Palmitic/stearic acid (50/50) ester of dipenta/pentaerythritol | Emery Oleochemicals |

### Blending, Extrusion, and Molding Conditions

The compositions were made as follows. All solid were dry blended off-line as concentrates using one of the primary polymer powders as a carrier and starve-fed via gravimetric feeder(s) into the feed throat of the extruder. The remaining polymer(s) were starve-fed via gravimetric feeder(s) into the feed throat of the extruder as well. The liquid additives, if any, were fed before the vacuum using a liquid injection system. It will be recognized by one skilled in the art that the method is not limited to these processing steps or processing equipment.

Extrusion of all materials was performed on a 25 mm Werner-Pfleiderer ZAK twin-screw extruder (L/D ratio of 33/1) with a vacuum port located near the die face. The extruder has 9 zones, which were set at temperatures of 40 °C (feed zone), 200 °C (zone 1), 250 °C (zone 2), 270 °C (zone 3) and 280-300 °C (zone 4 to 8). Screw speed was 300 rpm and throughput was between 15 and 25 kg/hr. It will be recognized by one skilled in the art that the method is not limited to these temperatures or processing equipment.

The compositions were molded after drying at 100-110°C for 6 hours on a 45-ton Engel molding machine with 22 mm screw or 75-ton Engel molding machine with 30 mm screw operating at a temperature 270-300°C with a mold temperature of 70-90°C. It will be recognized by one skilled in the art that the method is not limited to these temperatures or processing equipment.

### Testing Methods.

Weight average molecular weight (Mw) determinations were performed using GPC using a cross linked styrene-divinyl benzene column, at a sample concentration of 1 milligram per milliliter, and as calibrated with bisphenol A homopolycarbonate standards. Samples were eluted at a flow rate of 1.0 ml/min with methylene chloride as the eluent.

The hydrolytic stability was measured in a homogeneous solution at elevated temperature (75 °C) over 120 hrs as follows: a solution of 1 gram of the polymer in 16 mL of 1,2-dichlorethane was prepared in a 2 oz bottle. From this solution was taken 10-15 drops which were added to 10 mL of methylene chloride containing toluene as an internal standard. The Mw of this material was obtained and used as the time zero sample. To the remaining 1,2-dichlorethane polymer solution was added a solution of 25 µL of DI water in 3.11 mL of methyl ethyl ketone. The sample was then placed in an oven at 75 °C for 120 hrs. After this time the Mw of the polymer was again measured and the results were reported as the percentage of Mw loss based on the time zero sample.

Metallization was performed on molded parts from a film gate injection set-up having dimensions 60mm x 60mm and a thickness of either 3 mm or 1.5 mm using the physical vapor deposition (PVD) process. The process deposited a 100 to 150 nm thick aluminum layer onto one side of the molded part under vacuum, followed by a protective plasma-deposited siloxane hard-coat of 50 nm. The initial metallization performance was assessed by two well-trained operators as acceptable ("OK") or not acceptable ("NOK").

"Defect onset temperature" (DOT) was determined as the highest temperature at which no visual defects appeared on a metallized sample after 1 hour of heat aging in an air circulating oven, exposing all sides of the sample (symmetric heating). The thermal treatment of the metallized samples was carried out at least 48 hours after the parts were metallized.

The reflection data of the metallized articles and the heat treated metallized articles was acquired on an X-rite 1-7 spectrophotometer according to ASTM D1003-00 using a 25 mm aperture under D65 illumination in specular reflection mode and 10 degrees observer.

Visual defects were measure by eye with a trained operator and by an increase in L*. There are two common modes of failure during thermal treatment of the metallized parts. The parts can become hazy with the result that these parts exhibit an increase in diffuse reflection, which can be measured as an increase in L* when the parts are measured in reflection mode under specular excluded conditions. The parts can also fail due to blistering, which may not give a significant increase in diffuse reflection but is determined by close inspection of the parts. Hence a failure is reported as "defect onset temperature" (DOT) and captures the temperature at which the heat treated part fails either the visual assessment or gives a high diffuse scattering i.e. high L* in specular reflection mode.

Tensile properties were measured in accordance with ISO 527 at 50 mm/min at room temperature on standard ISO tensile bars.

Notched Izod impact Strength ('INI') was determined in accordance with ISO 180 under a load of 5.5 J, at different temperatures including a temperature of 23°C or -30°C. ISO INI determinations were carried out on sample plaques of 3 mm thickness.

Melt volume rate ("MVR") was determined in accordance with ASTM D1238-04 under a load of 2.16 kg at 330 °C.

Glass transition temperature (Tg) was determined by differential scanning calorimetry (DSC) as per ASTM D3418 with a 20°C/min heating rate.

Vicat B value was determined according to ISO 306, Method B120.

Heat deflection temperature (HDT) was determined on a flat 80 x 10 x 4 mm bar with a 64 mm span according to ISO 75/Bf, at the pressures indicated.

Haze and transmission measurement by HazeGard (ASTM D1003-00) used injection molded samples of 3.2 mm thickness.

Visible transmission (Tvis) measurements were acquired on HAZE-GUARD plus from BYK-Gardner instruments. Visible transmission was determined by measuring haze in accordance with ASTM D-1003-00, Procedure A using an integrating sphere (0°/diffuse geometry), wherein the spectral sensitivity conforms to the Commission Internatinale de L'Eclairage) (CIE, 1931) standard spectral value under standard lamp D65.

### Example 1 Preparation of TerPC1

To a mixture of methylene chloride (22 L), DI water (9 L), BPA (2379 g, 10.42 mol), BPI (248.8 g, 0.8016 mol), p-cumylphenol (149.7 g, 0.8016 mol), triethylamine (30 ml), and sodium gluconate (10 g) in a 75L reactor equipped with mechanical stirring, recirculation line with pH probe, subsurface phosgene addition, chilled glycol condenser, caustic scrubber for exit gas, and caustic solution inlet was added at 70g/min a solution of PPPBP (1891 g, 4.81 mol) in 1224g of 33 % NaOH and 3190 g of DI water while phosgene (2350 g, 23.7 mol) was added at 80 g/min. Aqueous caustic (33 wt.%) was added as needed to maintain pH of 8 to 9 in the reactor. After 2698 g (27.3 mol) of phosgene was added, the reactor was then purged with nitrogen. A sample was pulled for GPC analysis. The material was rephosgenated again (for a total of 2904 g) and the Mw was determined. The process was repeated until the Mw increase was less than about 200 Daltons. The polymer mixture was transferred to the 100L work-up tank. It was purified on a centrifuge train where the brine phase was separated and the polymer solution in methylene chloride was extracted with aqueous HCl and then washed with deionized water until titratable chlorides were less than 5 ppm. The polymer solution was then steam precipitated and the resultant polymer dried under hot nitrogen until volatile levels were <0.4 wt.%. The Mw of the dried polymer was 22,600 +/-500.

### Examples 2-4 Preparation of TerPC2 to TerPC4

TerPC-2 through 4 were prepared according a similar procedure as described for TerPC-1 in Example 1 by adjusting the monomer ratios, endcap levels, and reagents accordingly.

### Comparative Example 1 Preparation of BPI/BPA copolymer with 57 mol% BPI

To a mixture of methylene chloride (22 L), DI water (9 L), BPA (1609 g, 7.05 mol), BPI (2901 g, 9.34mol), p-cumylphenol (146.0 g, 0.6967 mol), triethylamine (30 ml), and sodium gluconate (10 g) in a 75 L reactor equipped with mechanical stirring, recirculation line with pH probe, subsurface phosgene addition, chilled glycol condenser, caustic scrubber for exit gas, and caustic solution inlet was added phosgene (2699 g, 27.3 mol) at 80 g/min. Aqueous caustic (33 wt.%) was added as needed to maintain pH of 8-9 in the reactor. After the phosgene was added, the reactor was then purged with nitrogen. A sample was pulled for GPC analysis. The material was rephosgenated again (to a total of 2903 g) and the Mw was determined. The process was repeated until the Mw increase was less than about 200 Daltons. The polymer mixture was transferred to the 100L work-up tank. It was purified on a centrifuge train where the brine phase was separated and the polymer solution in methylene chloride was extracted with aqueous HCl and then washed with deionized water until titratable chlorides were less than 5ppm. The polymer solution was then steam precipitated and the resultant polymer dried under hot nitrogen until volatile levels were < 0.4 wt.%. The Mw of the dried polymer was 22,600 +/-500.

### Examples 5-12 and comparative examples 2 and 3

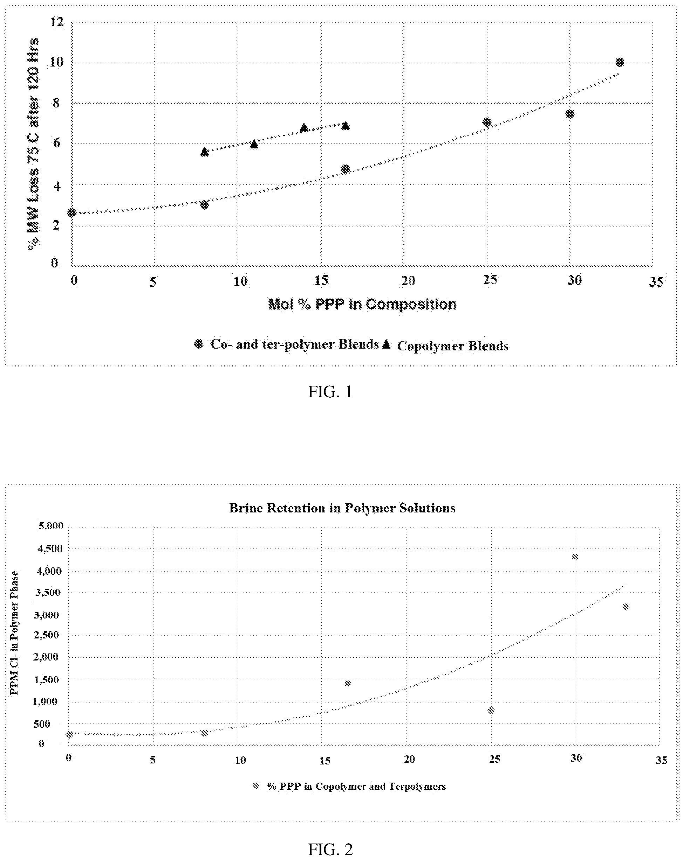

The molecular weight loss (Mw loss) of PPPBP-coPC, BPI-coPC, and the blends thereof were measured after heat aging at 75°C in a solution with water added after 120 hours. The results are shown in Tables 2 and 3 as well as FIG. 1. Lower Mw loss indicates a better hydrolytic stability.

**Table 2.**

| Component | Unit | CEx2 | Ex5 | Ex6 | Ex7 | Ex8 | CEx3 |
|---|---|---|---|---|---|---|---|
| PPPBP-coPC | Wt.% | 100 | | | | | |
| TerPC1 | Wt.% | | 100 | | | | |
| TerPC2 | Wt.% | | | 100 | | | |
| TerPC3 | Wt.% | | | | 100 | | |
| TerPC4 | Wt.% | | | | | 100 | |
| BPI-CoPC | Wt.% | | | | | | 100 |
| BPI units | Mol% | 0 | 5 | 15 | 29.5 | 44 | 57 |
| PPPBP units | Mol% | 33 | 30 | 25 | 16.5 | 8 | 0 |
| M_{W} loss at 120 hrs | % | 10 | 7 | 7 | 5 | 3 | 3 |

**Table 3.**

| Component | Unit | CEx9 | CEx10 | CEx11 | CEx12 |
|---|---|---|---|---|---|
| PPPBP-coPC | Wt.% | 50 | 42 | 33 | 24 |
| BPI-CoPC | Wt.% | 50 | 58 | 67 | 76 |
| BPI | Mol% | 28 | 33 | 38 | 43 |
| PPPBP | Mol% | 16.5 | 14 | 11 | 8 |
| M_{W} loss at 120 hrs | % | 6.9 | 6.8 | 6.0 | 5.6 |

The data shows that increasing the BPI units content or decreasing the PPPBP units content increases the hydrolytic stability of the polymers and blends. In addition the terpolymers have better stability than the blends at an equal Mol % PPPBP units level (FIG. 1).

### Examples 13-16 and Comparative Examples 4 and 5

Polycarbonates are often prepared by an interfacial process, which after the polymerization is complete affords a mixture of a polymer solution and a brine solution. Before isolation, the organic solution needs to be separated from the brine phase and washed to remove the catalysts and ionic impurities. Thus it is advantageous if the polymer solutions separate cleanly from the brine solutions and wash water. Polymers that do not split cleanly require extra washes and have an increase in product loss.

The chloride levels in the polymer solutions after separation from an aqueous phase was determined and the results are shown in Table 4 as well as FIG. 2.

**Table 4.**

| Component | Unit | CEx4 | Ex13 | Ex14 | Ex15 | Ex16 | CEx5 |
|---|---|---|---|---|---|---|---|
| PPPBP-coPC | Wt.% | 100 | | | | | |
| TerPC1 | Wt.% | | 100 | | | | |
| TerPC2 | Wt.% | | | 100 | | | |
| TerPC3 | Wt.% | | | | 100 | | |
| TerPC4 | Wt.% | | | | | 100 | |
| BPI-CoPC | Wt.% | | | | | | 100 |
| PPPBP units | Mol% | 33 | 30 | 25 | 16.5 | 8 | 0 |
| Cl in polymer phase | ppm | 3,182 | 4,328 | | | 267 | 228 |

The data from Table 4 and Figure 2 shows that terpolymers and PPPBP-coPC copolymers containing greater than or equal to 30 mol % PPPBP units have greater than 3,000 ppm of chloride entrained within the organic phase. Thus these polymer solutions will be more difficult to purify using liquid-liquid extractions.

### Examples 17-20 and Comparative Examples 6 and 7

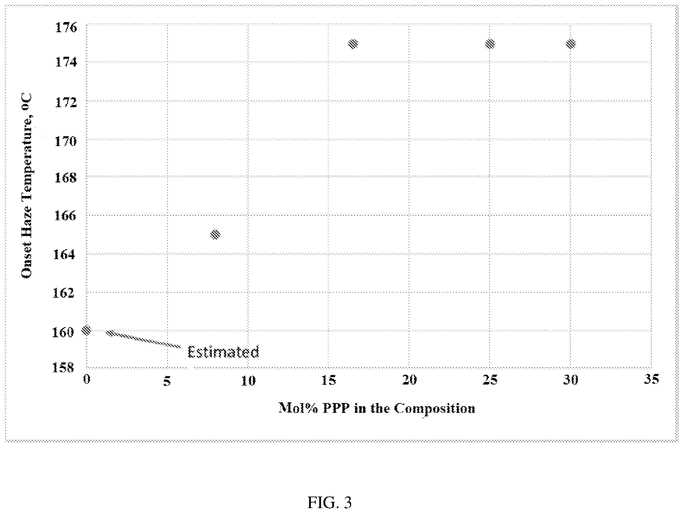

Terpolymers and BPI-coPC, PPPBP-coPC copolymers were tested for Tvis, haze, and MVR. The compositions were also evaluated as metalized reflectors. Results are shown in Table 5 and FIG. 3.

**Table 5.**

| Component | Unit | CEx6 | Ex 17 | Ex18 | Exl9 | Ex20 | CEx7 |
|---|---|---|---|---|---|---|---|
| TerPC1 | Wt.% | | 100 | | | | |
| TerPC2 | Wt.% | | | 100 | | | |
| TerPC3 | Wt.% | | | | 100 | | |
| TerPC4 | Wt.% | | | | | 100 | |
| BPI-coPC | Wt.% | | | | | | 100 |
| PPPBP-coPC | Wt.% | 100 | | | | | |
| BPI | Mol% | 0 | 5 | 15 | 30 | 44 | 57 |
| PPPBP | Mol% | 33 | 30 | 25 | 16.5 | 8 | 0 |
| BPA | Mol% | 67 | 65 | 60 | 54 | 48 | 43 |
| Tvis (3.2mm data) | expected | 86 | 81 | 85 | 87 | 89 | 88 |
| MVR 330°C / 2.16kg (300sec) | cc/10' | 31 | 23 | 23 | 24 | 19 | 23 |
| | | | | | | | |
| Tg, °C, at 20 °C/min | | 195 | 198 | 199 | 199 | 200 | 200 |
| Vicat (B 120) | °C | 186 | 188 | 189 | 190 | 192 | 192 |
| HDT (0.45MPa) | °C | 180 | 182 | 183 | 184 | 185 | 184 |
| IZOD 3mm | kJ/m² | 8 | 8 | 7 | 5 | 5 | 6 |
| 1.5 mm - metallized plaques | | | | | | | |
| DOT | °C | 175 | 175 | 175 | 175 | 165 | <165 |
| Heat treated at 165°C | P/F | | - | - | - | P | Bubbles |
| Heat treated at 170°C | P/F | | P | P | P | Bubbles | Bubbles |
| Heat treated at 175°C | P/F | P | P | P | P | - | - |
| Heat treated at 180°C | P/F | F | F | Bubbles | Bubbles | Bubbles | Bubbles |
| Delta HDT (0.45MPa) - DOT | ≤ 10°C | Yes | Yes | Yes | Yes | No | No |
| | | ≤10°C | ≤10°C | ≤10°C | ≤10°C | ≤20°C | >20°C |
| Metallized plaque before heat ageing | L* | 5 | 5 | 5 | 4 | 4 | 5 |
| Heat treated at 165°C | L* | | - | - | - | 4 | 15 |
| Heat treated at 170°C | L* | | 5 | 9 | 4 | 14 | 27 |
| Heat treated at 175°C | L* | 9 | 4 | 7 | 4 | - | - |
| Heat treated at 180°C | L* | 68 | 72 | 61 | 16 | 19 | 43 |

| | | | | | | | |
|---|---|---|---|---|---|---|---|
| *Each of the compositions in Table 5 contained hindered phenol, phosphite stabilizer, and the mold releasing agent. | | | | | | | |

As shown in Table 5 and FIG. 3, the defect onset temperatures (DOT) are dramatically increased with increasing PPPBP units content. Without the presence of PPPBP units, the DOT is less than 165 °C. The addition of as little as 8 mol % PPPBP units provides a 165 °C rating. Greater than 8 mol % PPPBP units increases the DOT to 175 °C.

Table 5 also shows that the terpolymers TerPC1-TerPC4 have melt flows at least as good as BPI-coPC (CEx 7).

The data also shows that the terpolymers, BPI-coPC, and PPPBP-coPC have comparable visible transparency (Tvis) and haze values.

### Examples 21-24 and Comparative Examples 8 and 9

Terpolymers and polycarbonate homopolymer blends having a Vicat B value of 164-166°C were tested for various physical properties. The formulations and the results are shown in Table 6.

**Table 6.**

| Component | Unit | CEx 8 | Ex 21 | Ex 22 | Ex 23 | Ex 24 | CEx 9 |
|---|---|---|---|---|---|---|---|
| TerPC1 | Wt.% | | | | | 53 | |
| TerPC2 | Wt.% | | | | 53 | | |
| TerPC3 | Wt.% | | | 53 | | | |
| TerPC4 | Wt.% | | 52 | | | | |
| BPI-coPC | Wt.% | 52 | | | | | |
| PPPBP-coPC | Wt.% | | | | | | 55 |
| PC1 | Wt.% | 48 | 48 | 47 | 47 | 47 | 45 |
| Blend composition: BPI | mol% | 29.6 | 22.9 | 15.6 | 8.0 | 2.7 | 0 |
| PPPBP | mol% | 0 | 4.2 | 8.7 | 13.3 | 15.9 | 18.2 |
| BPA | mol% | 70.4 | 73.0 | 75.6 | 78.8 | 81.5 | 81.9 |
| MVR 300°C / 2.16kg (300sec) | cc/10' | 27 | 27 | 24 | 23 | 25 | 25 |
| Vicat B 120 | °C | 165 | 165 | 166 | 165 | 164 | 166 |
| 3 mm IZOD - 5.5J Pendulum | | | | | | | |
| Notched Impact Strength 23 °C | kJ/m² | 6 | 6 | 7 | 8 | 8 | 9 |
| Notched Impact Strength -30 °C | kJ/m² | 6 | 7 | 7 | 7 | 8 | 9 |
| Vicat (B 120) | °C | 165 | 165 | 166 | 165 | 164 | 166 |
| HDT 0.45 MPa/Flat (330 °C) | °C | 159 | 158 | 159 | 159 | 157 | 159 |
| HDT 1.8 MPa/Flat (330 °C) | °C | 149 | 148 | 148 | 149 | 148 | 148 |
| IZOD 3mm | kJ/m² | 6 | 6 | 7 | 8 | 8 | 9 |
| 1.5 mm - metallized plaques | | | | | | | |
| Visual inspection | | OK | OK | OK | OK | OK | OK |
| Defect | | - | - | - | - | - | |
| DOT | °C | <150 | 155 | 155 | 155 | 155 | 155 |
| Haze treated at 150 °C | | Bubbles | | | | | |
| Haze treated at 155 °C | P/F | Bubbles | P | P | P | P | P |
| Haze treated at 160 °C | P/F | F | F | F | F | F | F |
| Haze treated at 165 °C | P/F | - | - | - | - | - | - |
| Delta HDT (0.45MPa) - DOT | ≤ 10 °C | No | Yes | Yes | Yes | Yes | Yes |
| Metallized plaque before heat aging | L* | 7 | 6 | 6 | 6 | 7 | 6 |
| Haze treated at 150 °C | L* | 11 | | | | | |
| Haze treated at 155 °C | L* | 10 | 9 | 11 | 11 | 15 | 15 |
| Haze treated at 160 °C | L* | 71 | 70 | 75 | 73 | 75 | 62 |
| Haze treated at 165 °C | L* | - | - | - | - | - | - |

| | | | | | | | |
|---|---|---|---|---|---|---|---|
| *Each of the compositions in Table 6 contained hindered phenol, phosphite stabilizer, and the mold releasing agent. | | | | | | | |

The data shows that with the presence of PPPBP units in the blend, a stable mirror like reflection was achieved at 155 °C. Without PPPBP units in the composition, the blends fail the defect onset temperature test at 155 °C showing the need for PPPBP units in the composition. Although CEx 9, which contains 55 wt.% of PPPBP-coPC and 45 wt.% of PC1, passes the defect onset temperature test at 155 °C, PPPBP-coPC has poorer hydrolytic stability and propensity to separate from an aqueous phase when dissolved in an organic solvent.

### Examples 25-28 and Comparative Examples 10 and 11

Terpolymers and polycarbonate homopolymer blends having a Vicat B value of 167-171°C were tested for various physical properties. The formulations and the results are shown in Table 7.

**Table 7.**

| Component | Unit | CEx 10 | Ex. 25 | Ex. 26 | Ex. 27 | Ex. 28 | CEx11 |
|---|---|---|---|---|---|---|---|
| TerPC1 | wt.% | | | | | 61 | |
| TerPC2 | wt.% | | | | 60 | | |
| TerPC3 | wt.% | | | 60 | | | |
| TerPC4 | wt.% | | 60 | | | | |
| BPI-coPC | wt.% | 60 | | | | | |
| PPPBP-coPC | wt.% | | | | | | 64 |
| PC1 | wt.% | 40 | 40 | 40 | 40 | 39 | 36 |
| Terpolymer composition: BPI | mol% | 57 | 44 | 30 | 15 | 5 | 0 |
| PPPBP | mol% | 0 | 8 | 17 | 25 | 30 | 33 |
| BPA | mol% | 43 | 48 | 54 | 60 | 65 | 67 |
| Blend composition: BPI | mol% | 34.2 | 26.4 | 17.7 | 9.0 | 3.1 | 0.0 |
| PPPBP | mol% | 0.0 | 4.8 | 9.9 | 15.0 | 18.3 | 21.1 |
| BPA | mol% | 65.8 | 68.8 | 72.4 | 76.0 | 78.7 | 78.9 |
| MVR 300°C / 2.16kg (300sec) | cc/10' | 23 | 21 | 22 | 19 | 21 | 18 |
| Vicat B 120 | °C | 169 | 169 | 170 | 169 | 167 | 171 |
| HDT 0.45 MPa/Flat (330 °C) | °C | 162 | 163 | 162 | 162 | 161 | 163 |
| HDT 1.8 MPa/Flat (330 °C) | °C | 151 | 151 | 150 | 151 | 152 | 152 |
| 3 mm IZOD - 5.5J Pendulum | | | | | | | |
| Notched Impact Strength 23 °C | kJ/m² | 6 | 6 | 7 | 8 | 8 | 9 |
| 1.5 mm - metallized plaques | | | | | | | |
| Visual inspection | | OK | OK | OK | OK | OK | OK |
| Defect | | - | - | - | - | - | - |
| DOT | °C | <150 | 155 | 155 | 155 | 155 | 160 |
| Haze treated at 150 °C | °C | Bubbles | | | | | |
| Haze treated at 155 °C | P/F | Bubbles | P | P | P | P | P |
| Haze treated at 160 °C | P/F | Bubbles | Bubbles | F | F | F | P |
| Haze treated at 165 °C | P/F | F | F | F | F | - | F |
| Delta HDT (0.45MPa) - DOT | ≤ 10 °C | No | Yes | Yes | Yes | Yes | Yes |
| Metallized plaque before heat ageing | L* | 6 | 6 | 7 | 5 | 5 | 4 |
| Haze treated at 150 °C | L* | 10 | | | | | |
| Haze treated at 155 °C | L* | 11 | 10 | 11 | 7 | 8 | 14 |
| Haze treated at 160 °C | L* | 22 | 17 | 28 | 57 | 79 | 15 |
| Haze treated at 165 °C | L* | 67 | 70 | 73 | 83 | - | 24 |

| | | | | | | | |
|---|---|---|---|---|---|---|---|
| *Each of the compositions in Table 8 contained hindered phenol, phosphite stabilizer, and the mold releasing agent. | | | | | | | |

The data shows that with the presence of PPPBP units in the blend, a stable mirror like reflection was achieved at 155 °C. Without PPPBP units in the composition, the blends fail the heat onset temperature test at 155 °C showing the need for PPPBP units in the composition. Although CEx 11, which contains 64 wt.% of PPPBP-coPC and 36 wt.% of PC1, passes the defect onset temperature test at 155 °C, PPPBP-coPC has poorer hydrolytic stability and propensity to separate from an aqueous phase when dissolved in an organic solvent.

In summary, although the heat performance (Tg, VICAT, and HDT) is considered an important factor in the selection of high temperature reflector compositions, the examples show that not all high heat compositions are effective at maintaining an metal coated optical surface at high temperatures as would be expected based on the Tg of the composition. Surprisingly the inventors have found that by the use of terpolymers of BPI, PPP and BPA, it is possible to provide polymers and polymer blends with an excellent balance of melt flow, high heat performance, high temperature robustness of the reflection, and hydrolytic stability. In addition, the addition of BPI units to the terpolymer not only improves the hydro-stability, but also improves the ability of the terpolymers to be readily purified in liquid-liquid extractions.

Set forth below are specific embodiments of copolycarbonates, thermoplastic compositions comprising the copolycarbonates, and article comprising the copolycarbonates or the thermoplastic compositions.
Embodiment 1. A copolycarbonate comprising first repeating units, second repeating units different from the first repeating units, and third repeating units different from the first and second repeating units; and wherein the first repeating units are phthalimidine carbonate units of the formula 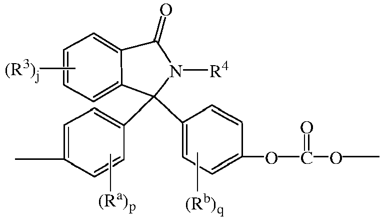 wherein R^{a} and R^{b} are each independently a C₁₋₁₂ alkyl, C₂₋₁₂ alkenyl, C₃₋₈ cycloalkyl, or C₁₋₁₂ alkoxy, each R³ is independently a C₁₋₆ alkyl, R⁴ is hydrogen, C₂₋₆ alkyl or phenyl optionally substituted with 1 to 5 C₁₋₆ alkyl groups, p, q, and j are each independently 0 to 4, the second repeating units are carbonate units of the formula 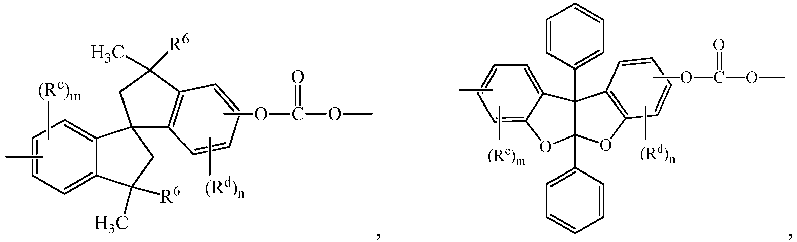 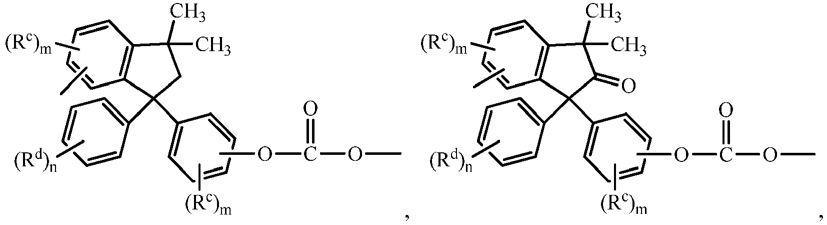 or 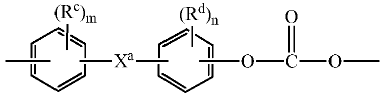 wherein R^{c} and R^{d} are each independently a C₁₋₁₂ alkyl, C₂₋₁₂ alkenyl, C₃₋₈ cycloalkyl, or C₁₋₁₂ alkoxy, each R⁶ is independently C₁₋₃ alkyl or phenyl; X^{a} is a C₆₋₁₂ polycyclic aryl, C₃₋₁₈ mono- or polycycloalkylene, C₃₋₁₈ mono- or polycycloalkylidene, -(Q¹)ₓ-G-(Q²)_{y}- group wherein Q¹ and Q² are each independently a C₁₋₃ alkylene, G is a C₃₋₁₀ cycloalkylene, x is 0 or 1, and y is 1; and m and n are each independently 0 to 4; and the third repeating units are carbonate units of the formula 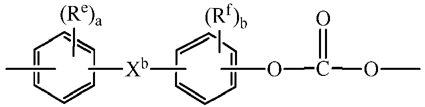 wherein R^{e} and R^{f} are each independently C₁₋₁₂ alkyl, C₁₋₁₂ alkenyl, C₃₋₈ cycloalkyl, or C₁₋₁₂ alkoxy, a and b are each independently integers of 0 to 4, and X^{b} is a single bond, -O-, -S-, - S(O)-, -S(O)₂-, -C(O)-, or C₁₋₃₂ bridging hydrocarbon group, provided that X^{b} is not a phthalimidine group or X^{a}.
Embodiment 2. The copolycarbonate of Embodiment 1, wherein the first repeating units are phthalimidine carbonate units of the formula 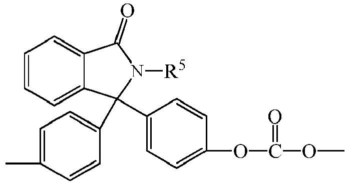 wherein R⁵ is phenyl.
Embodiment 3. The copolycarbonate of Embodiment 1 or Embodiment 2, wherein the second repeating units have the structural formula 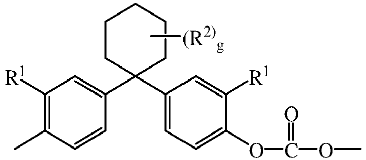 wherein each R¹ is independently hydrogen or C₁₋₄ alkyl, each R² is independently C₁₋₄ alkyl or hydrogen, and g is 0 to 10.
Embodiment 4. The copolycarbonate of Embodiment 3, wherein R¹ is methyl or hydrogen, R² is methyl or ethyl, and g is 0 to 3.
Embodiment 5. The copolycarbonate of any one or more of Embodiments 1 to 4, wherein the second repeating units are 1,1-bis(4-hydroyphenyl)-3,3,5-trimethylcyclohexane carbonate units.
Embodiment 6. The copolycarbonate of Embodiment 1 or Embodiment 2, wherein the second repeating units are carbonate units of the formula: 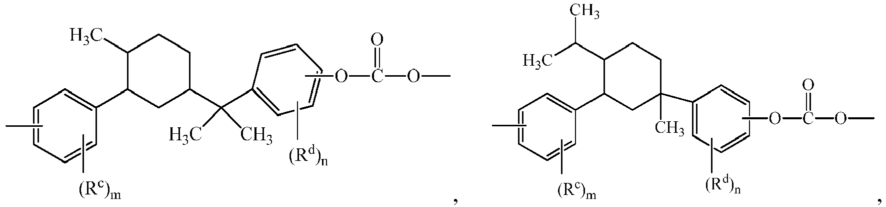 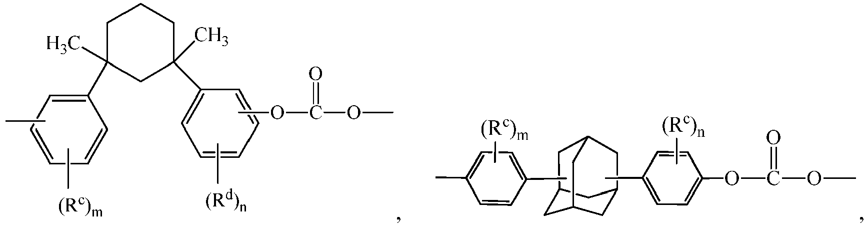 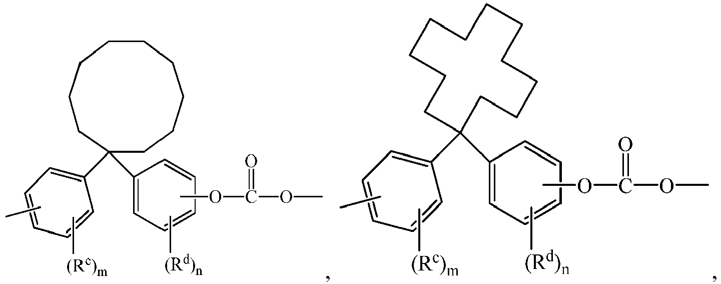 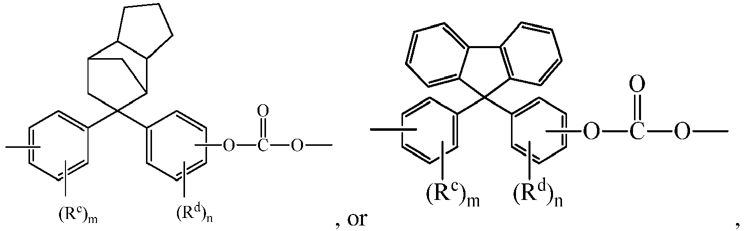 wherein R^{c} and R^{d} are each independently a C₁₋₁₂ alkyl, C₂₋₁₂ alkenyl, C₃₋₈ cycloalkyl, or C₁₋₁₂ alkoxy; and m and n are each independently 0 to 4.
Embodiment 7. The copolycarbonate of any one of more of Embodiments 1 to 6, wherein the third repeating units are bisphenol A carbonate units.
Embodiment 8. The copolycarbonate of any one or more of Embodiments 1 to 7, wherein the copolycarbonate comprises 3 mol% to 28 mol% of the first repeating units based on the sum of moles of the first repeating units, second repeating units, and third repeating units.
Embodiment 9. The copolycarbonate of any one or more of Embodiments 1 to 8, wherein the copolycarbonate comprises 4 mol% to 20 mol% of the second repeating units based on the sum of moles of the first repeating units, second repeating units, and third repeating units.
Embodiment 10. The copolycarbonate of any one or more of Embodiments 1 to 8, wherein the copolycarbonate comprises 45 mol% to 70 mol% of the third repeating units based on the sum of moles of the first repeating units, second repeating units, and third repeating units.
Embodiment 11. The copolycarbonate of any one or more of Embodiments 1 to 10, wherein the first repeating units are N-phenyl phenolphthalein bisphenol carbonate units, the second repeating units are 1,1-bis-(4-hydroxyphenyl)-3,3,5-trimethylcyclohexane carbonate units, and the third repeating units are bisphenol A carbonate units; and wherein the first, second, and third repeating units are present in an amount of 3 mol% to 28 mol%, 4 mol% to 20 mol%, and 45 mol% to 79 mol% respectively, each based on the sum of moles of the first repeating units, second repeating units, and third repeating units.
Embodiment 12. A thermoplastic composition comprising the copolycarbonate of any one or more of Embodiments 1 to 11.
Embodiment 13. The thermoplastic composition of Embodiment 12 further comprising a polycarbonate homopolymer.
Embodiment 14. The thermoplastic composition of Embodiment 13, wherein the polycarbonate homopolymer is a bisphenol A homopolycarbonate.
Embodiment 15. The thermoplastic composition of Embodiment 13 or 14, wherein the polycarbonate homopolymer is present in an amount of 30 wt.% to 60 wt.% based on the total weight of the composition.
Embodiment 16. The thermoplastic composition of any one or more of Embodiments 12 to 15, further comprising a poly(ester-carbonate).
Embodiment 17. The copolycarbonate or the composition of any one or more of Embodiments 1 to 16, wherein a metalized sample of the copolycarbonate or the composition has a defect onset temperature that is within 20 degrees Celsius of the heat deflection temperature of the copolycarbonate or composition measured flat on a 80 x 10 x 4 mm bar with a 64 mm span at 0.45 MPa according to ISO 75/Bf.
Embodiment 18. An article, wherein the article a molded article, a thermoformed article, an extruded film, an extruded sheet, one or more layers of a multi-layer article, a substrate for a coated article, or a substrate for a metallized article made from the copolycarbonate or composition of any one or more of Embodiments 1 to 17.
Embodiment 19. A metallized article comprising the copolycarbonate or composition of any one or more of Embodiments 1 to 17 wherein the defect onset temperature of the metallized article is within 20 degrees Celsius of the heat deflection temperature of the copolycarbonate or the composition measured flat on a 80 x 10 x 4 mm bar with a 64 mm span at 0.45 MPa according to ISO 75/Bf.
Embodiment 20. A metallized article, comprising a substrate comprising the copolycarbonate or composition of any one of Embodiments 1-17; and a metal layer disposed on at least one side of the substrate.
Embodiment 21. The article of Embodiment 20, further comprising a protective layer disposed on the metal layer.

The singular forms "a," "an," and "the" include plural referents unless the context clearly dictates otherwise. "Or" means "and/or." The endpoints of all ranges directed to the same component or property are inclusive and independently combinable. Unless defined otherwise, technical and scientific terms used herein have the same meaning as is commonly understood by one of skill in the art to which this invention belongs. As used herein, a "combination" is inclusive of blends, mixtures, alloys, reaction products, and the like.

Compounds are described using standard nomenclature. For example, any position not substituted by any indicated group is understood to have its valency filled by a bond as indicated, or a hydrogen atom. A dash ("-") that is not between two letters or symbols is used to indicate a point of attachment for a substituent. For example, -CHO is attached through carbon of the carbonyl group.

As used herein, the term "hydrocarbyl" and "hydrocarbon" refers broadly to a substituent comprising carbon and hydrogen, optionally with 1 to 3 heteroatoms, for example, oxygen, nitrogen, halogen, silicon, sulfur, or a combination thereof; "alkyl" refers to a straight or branched chain, saturated monovalent hydrocarbon group; "alkylene" refers to a straight or branched chain, saturated, divalent hydrocarbon group; "alkylidene" refers to a straight or branched chain, saturated divalent hydrocarbon group, with both valences on a single common carbon atom; "alkenyl" refers to a straight or branched chain monovalent hydrocarbon group having at least two carbons joined by a carbon-carbon double bond; "cycloalkyl" refers to a non-aromatic monovalent monocyclic or multicylic hydrocarbon group having at least three carbon atoms; "cycloalkylene" refers to a divalent radical formed by the removal of two hydrogen atoms from two different carbon atoms on one or more rings of a cycloalkyl group; "aryl" refers to an aromatic monovalent group containing only carbon in the aromatic ring or rings; "arylene" refers to an aromatic divalent group containing only carbon in the aromatic ring or rings; "alkylaryl" refers to an aryl group that has been substituted with an alkyl group as defined above, with 4-methylphenyl being an exemplary alkylaryl group; "arylalkyl" refers to an alkyl group that has been substituted with an aryl group as defined above, with benzyl being an exemplary arylalkyl group; "acyl" refers to an alkyl group as defined above with the indicated number of carbon atoms attached through a carbonyl carbon bridge (-C(=O)-); "alkoxy" refers to an alkyl group as defined above with the indicated number of carbon atoms attached through an oxygen bridge (-O-); and "aryloxy" refers to an aryl group as defined above with the indicated number of carbon atoms attached through an oxygen bridge (-O-).

Unless otherwise indicated, each of the foregoing groups can be unsubstituted or substituted, provided that the substitution does not significantly adversely affect synthesis, stability, or use of the compound. The term "substituted" as used herein means that at least one hydrogen on the designated atom or group is replaced with another group, provided that the designated atom's normal valence is not exceeded. When the substituent is oxo (i.e., =O), then two hydrogens on the atom are replaced. Combinations of substituents or variables are permissible provided that the substitutions do not significantly adversely affect synthesis or use of the compound. Groups that can be present on a substituted position include a nitro functional group (-NO₂), cyano (-CN), hydroxy (-OH), halogen, thiol (-SH), thiocyano (-SCN), C₂₋₆ alkanoyl (e.g., acyl (H3CC(=O)-); carboxamido; C₁₋₆ or C₁₋₃ alkyl, cycloalkyl, alkenyl, and alkynyl (including groups having at least one unsaturated linkages and from 2 to 8, or 2 to 6 carbon atoms); C₁₋₆ or C₁₋₃ alkoxy; C₆₋₁₀ aryloxy such as phenoxy; C₁₋₆ alkylthio; C₁₋₆ or C₁₋₃ alkylsulfinyl; C₁₋₆ or C₁₋₃ alkylsulfonyl; aminodi(C₁₋₆ or C₁₋₃)alkyl; C₆₋₁₂ aryl having at least one aromatic rings (e.g., phenyl, biphenyl, naphthyl, or the like, each ring either substituted or unsubstituted aromatic); C₇₋₁₉ arylalkyl having 1 to 3 separate or fused rings and from 6 to 18 ring carbon atoms; or arylalkoxy having 1 1 to 3 separate or fused rings and from 6 to 18 ring carbon atoms..

While typical embodiments have been set forth for the purpose of illustration, the foregoing descriptions should not be deemed to be a limitation on the scope herein. Accordingly, various modifications, adaptations, and alternatives can occur to one skilled in the art without departing from the scope herein.

## Claims

1. A copolycarbonate comprising first repeating units, second repeating units different from the first repeating units, and third repeating units different from the first and second repeating units; and wherein
the first repeating units are phthalimidine carbonate units of the formula 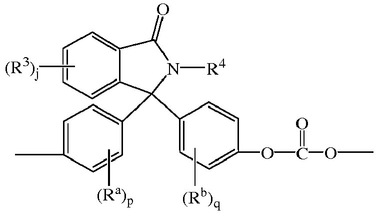 wherein
R^{a} and R^{b} are each independently a C₁₋₁₂ alkyl, C₂₋₁₂ alkenyl, C₃₋₈ cycloalkyl, or C₁₋₁₂ alkoxy,
each R³ is independently a C₁₋₆ alkyl,
R⁴ is hydrogen, C₂₋₆ alkyl or phenyl optionally substituted with 1 to 5 C₁₋₆ alkyl groups,
p, q, and j are each independently 0 to 4,
the second repeating units are carbonate units of the formula 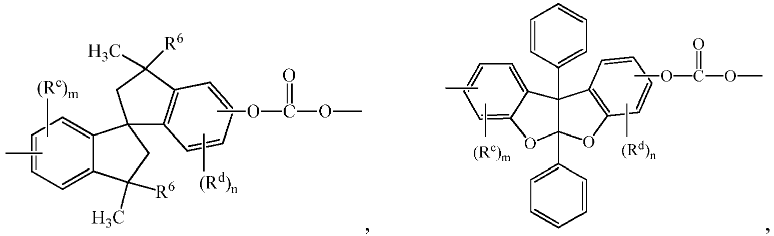 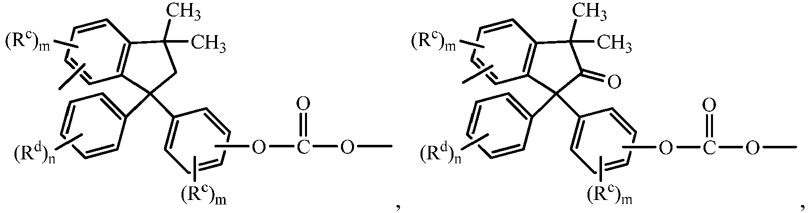 or 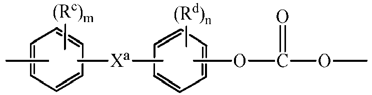 wherein
R^{c} and R^{d} are each independently a C₁₋₁₂ alkyl, C₂₋₁₂ alkenyl, C₃₋₈ cycloalkyl, or C₁₋₁₂ alkoxy,
each R⁶ is independently C₁₋₃ alkyl or phenyl;
X^{a} is a C₆₋₁₂ polycyclic aryl, C₃₋₁₈ mono- or polycycloalkylene, C₃₋₁₈ mono- or polycycloalkylidene, -(Q¹²)ₓ-G-(Q²)_{y}- group wherein Q¹ and Q² are each independently a C₁₋₃ alkylene, G is a C₃₋₁₀ cycloalkylene, x is 0 or 1, and y is 1; and
m and n are each independently 0 to 4; and
the third repeating units are carbonate units of the formula wherein 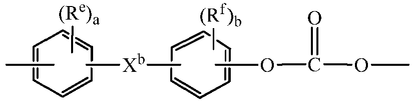
R^{e} and R^{f} are each independently C₁₋₁₂ alkyl, C₂₋₁₂ alkenyl, C₃₋₈ cycloalkyl, or C₁₋₁₂ alkoxy,
a and b are each independently integers of 0 to 4, and
X^{b} is a single bond, -O-, -S-, -S(O)-, -S(O)₂-, -C(O)-, or C₁₋₃₂ bridging hydrocarbon group, provided that X^{b} is not a phthalimidine group or X^{a}.

2. The copolycarbonate of claim 1, wherein the first repeating units are phthalimidine carbonate units of the formula 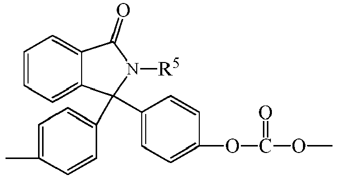 wherein R⁵ is phenyl.

3. The copolycarbonate of claim 1 or claim 2, wherein the second repeating units have the structural formula 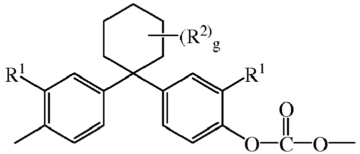 wherein
each R¹ is independently hydrogen or C₁₋₄ alkyl,
each R² is independently C₁₋₄ alkyl or hydrogen, and
g is 0 to 10.

4. The copolycarbonate of claim 3, wherein R¹ is methyl or hydrogen, R² is methyl or ethyl, and g is 0 to 3.

5. The copolycarbonate of any one or more of claims 1 to 4, wherein the second repeating units are 1,1-bis(4-hydroyphenyl)-3,3,5-trimethyl-cyclohexane carbonate units.

6. The copolycarbonate of claim 1 or claim 2, wherein the second repeating units are carbonate units of the formula: 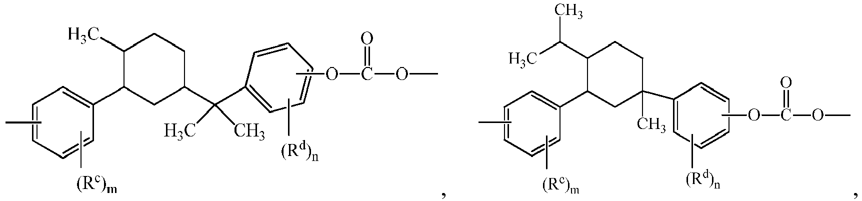 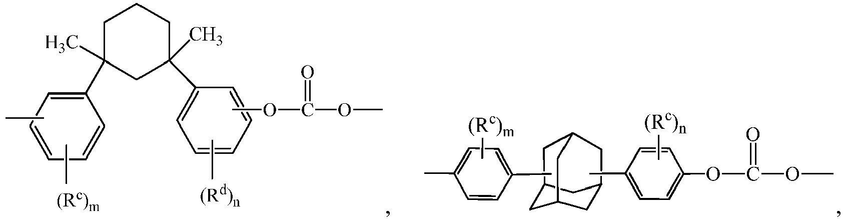 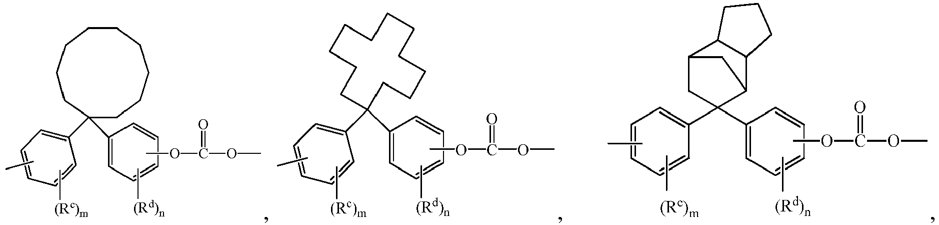 or 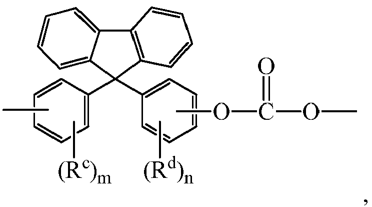 wherein
R^{c} and R^{d} are each independently a C₁₋₁₂ alkyl, C₁₋₁₂ alkenyl, C₃₋₈ cycloalkyl, or C₁₋₁₂ alkoxy; and
m and n are each independently 0 to 4.

7. The copolycarbonate of any one of more of claims 1 to 6, wherein the third repeating units are bisphenol A carbonate units.

8. The copolycarbonate of any one or more of claims 1 to 7, wherein the copolycarbonate comprises 3 mol% to 28 mol% of the first repeating units, 4 mol% to 20 mol% of the second repeating units, and 45 mol% to 70 mol% of the third repeating units, each based on the sum of moles of the first repeating units, second repeating units, and third repeating units.

9. A thermoplastic composition comprising the copolycarbonate of any one or more of claims 1 to 8.

10. The thermoplastic composition of claim 9 further comprising a polycarbonate homopolymer, a poly(ester-carbonate), or a combination thereof, optionally wherein the polycarbonate homopolymer is a bisphenol A homopolycarbonate.

11. The thermoplastic composition of claim 10, wherein the polycarbonate homopolymer is present in an amount of 30 wt.% to 60 wt.% based on the total weight of the composition.

12. An article, wherein the article a molded article, a thermoformed article, an extruded film, an extruded sheet, one or more layers of a multi-layer article, a substrate for a coated article, or a substrate for a metallized article made from the copolycarbonate or composition of any one or more of claims 1 to 11.

13. A metallized article comprising the copolycarbonate or composition of any one or more of claims 1 to 11 wherein the defect onset temperature of the metallized article is within 20 degrees Celsius of the heat deflection temperature of the copolycarbonate or the composition measured flat on a 80 x 10 x 4 mm bar with a 64 mm span at 0.45 MPa according to ISO 75/Bf.

14. A metallized article, comprising
a substrate comprising the copolycarbonate or composition of any one of claims 1-11; and
a metal layer disposed on at least one side of the substrate.

15. The article of claim 14, further comprising a protective layer disposed on the metal layer.

## Patentansprüche

1. Ein Copolycarbonat umfassend erste sich wiederholende Einheiten, zweite sich wiederholende Einheiten, die sich von den ersten sich wiederholenden Einheiten unterscheiden, und dritte sich wiederholende Einheiten, die sich von den ersten und den zweiten sich wiederholenden Einheiten unterscheiden;
und worin
die ersten sich wiederholenden Einheiten Phthalimidincarbonateinheiten der Formel 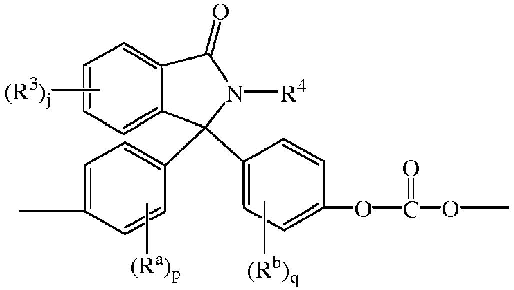 sind, worin
R^{a} und R^{b} jeweils unabhängig ein C₁₋₁₂ Alkyl, C₂₋₁₂ Alkenyl, C₃₋₈ Cycloalkyl, oder C₁₋₁₂ Alkoxy sind,
jedes R³ ist unabhängig ein C₁₋₆ Alkyl,
R⁴ ist Wasserstoff, C₂₋₆ Alkyl oder Phenyl wahlweise substituiert mit 1 bis 5 C₁₋₆ Alkylgruppen,
p, q und j sind jeweils unabhängig 0 bis 4,
die zweiten sich wiederholenden Einheiten sind Carbonateinheiten der Formel 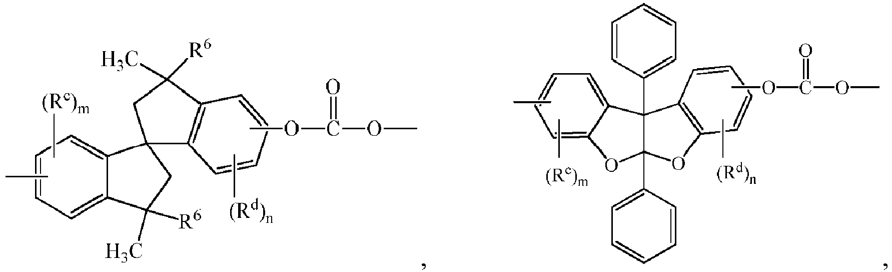 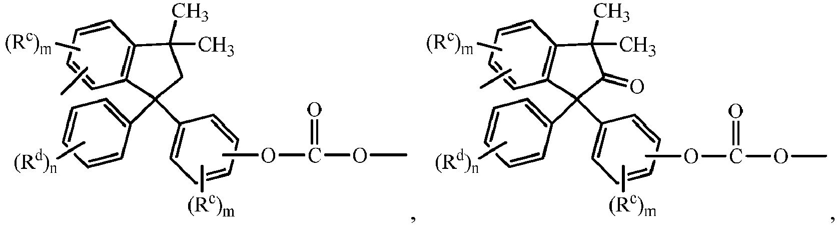 oder 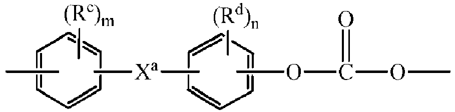 worin
R^{c} und R^{d} jeweils unabhängig ein C₁₋₁₂ Alkyl, C₂₋₁₂ Alkenyl, C₃₋₈ Cycloalkyl, oder C₁₋₁₂ Alkoxy sind,
jedes R⁶ ist unabhängig C₁₋₃ Alkyl oder Phenyl;
X^{a} ist ein C₆₋₁₂ polyzyklisches Aryl, C₃₋₁₈ Mono- oder Polycycloalkylen, C₃₋₁₈ Mono- oder Polycycloalkyliden, eine -(Q¹)ₓ-G-(Q²)_{y}-Gruppe, worin Q¹ und Q² jeweils unabhängig ein C₁₋₃ Alkylen sind, G ist ein C₃₋₁₀ Cycloalkylen, x ist 0 oder 1, und y ist 1;
und
m und n sind jeweils unabhängig 0 bis 4; und
die dritten sich wiederholenden Einheiten sind Carbonateinheiten der Formel 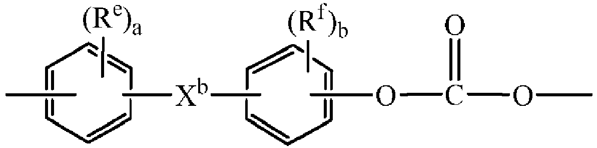 worin
R^{e} und R^{f} jeweils unabhängig C₁₋₁₂ Alkyl, C₂₋₁₂ Alkenyl, C₃₋₈ Cycloalkyl, oder C₁₋₁₂ Alkoxy sind,
a und b sind jeweils unabhängig ganze Zahlen von 0 bis 4, und
X^{b} ist eine Einzelbindung, -O-, -S-, -S(O)-, -S(O)₂-, -C(O)-, oder eine C₁₋₃₂ überbrückende Kohlenwasserstoffgruppe, vorausgesetzt, dass X^{b} keine Phthalimidingruppe oder X^{a} ist.

2. Das Copolycarbonat gemäß Anspruch 1, worin die ersten sich wiederholenden Einheiten Phthalimidincarbonateinheiten der Formel 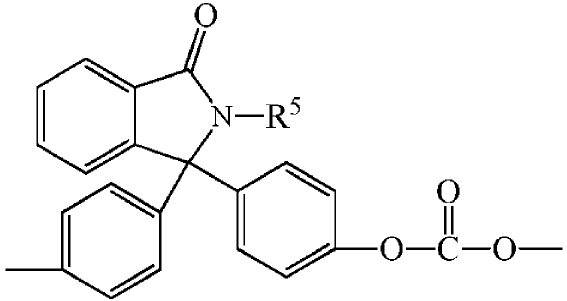 sind,
worin R⁵ Phenyl ist.

3. Das Copolycarbonat gemäß Anspruch 1 oder Anspruch 2, worin die zweiten sich wiederholenden Einheiten die Strukturformel 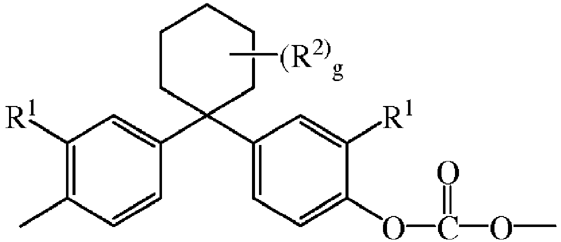 haben,
worin
jedes R¹ unabhängig Wasserstoff oder C₁₋₄ Alkyl ist,
jedes R² ist unabhängig C₁₋₄ Alkyl oder Wasserstoff, und
g ist 0 bis 10.

4. Das Copolycarbonat gemäß Anspruch 3, worin R¹ Methyl oder Wasserstoff ist, R² ist Methyl oder Ethyl, und g ist 0 bis 3.

5. Das Copolycarbonat gemäß irgendeinem oder mehreren der Ansprüche 1 bis 4, worin die zweiten sich wiederholenden Einheiten 1,1-bis(4-Hydroxyphenyl)-3,3,5-trimethyl-cyclohexancarbonateinheiten sind.

6. Das Copolycarbonat gemäß Anspruch 1 oder Anspruch 2, worin die zweiten sich wiederholenden Einheiten Carbonateinheiten der Formel: 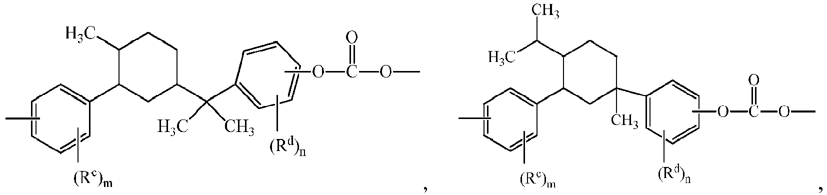 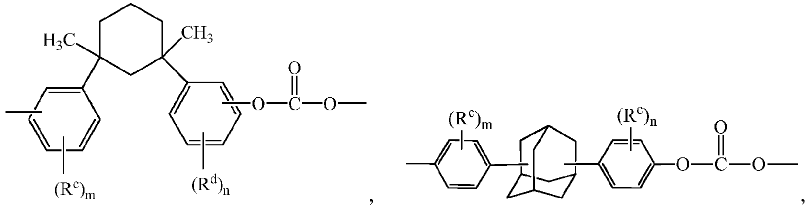 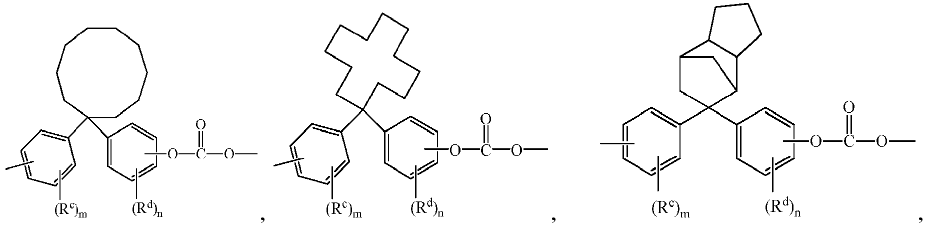 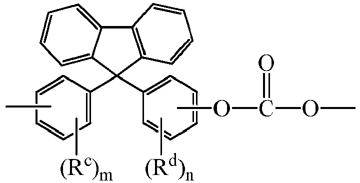 , oder sind,
worin
R^{c} und R^{d} jeweils unabhängig ein C₁₋₁₂ Alkyl, C₁₋₁₂ Alkenyl, C₃₋₈ Cycloalkyl, oder C₁₋₁₂ Alkoxy sind; und
m und n sind jeweils unabhängig 0 bis 4.

7. Das Copolycarbonat gemäß irgendeinem oder mehreren der Ansprüche 1 bis 6, worin die dritten sich wiederholenden Einheiten Bisphenol A Carbonateinheiten sind.

8. Das Copolycarbonat gemäß irgendeinem oder mehreren der Ansprüche 1 bis 7, worin das Copolycarbonat 3 Mol% bis 28 Mol% der ersten sich wiederholenden Einheiten, 4 Mol% bis 20 Mol% der zweiten sich wiederholenden Einheiten, und 45 Mol% bis 70 Mol% der dritten sich wiederholenden Einheiten umfasst, jeweils basierend auf der Summe der Mole der ersten sich wiederholenden Einheiten, der zweiten sich wiederholenden Einheiten und der dritten sich wiederholenden Einheiten.

9. Eine thermoplastische Zusammensetzung umfassend das Copolycarbonat gemäß irgendeinem oder mehreren der Ansprüche 1 bis 8.

10. Die thermoplastische Zusammensetzung gemäß Anspruch 9, weiter umfassend ein Polycarbonathomopolymer, ein Poly(ester-carbonat), oder eine Kombination daraus, wahlweise worin das Polycarbonathomopolymer ein Bisphenol A Homopolycarbonat ist.

11. Die thermoplastische Zusammensetzung gemäß Anspruch 10, worin das Polycarbonathomopolymer in einer Menge von 30 Gewichts% bis 60 Gewichts% vorhanden ist, basierend auf dem Gesamtgewicht der Zusammensetzung.

12. Ein Artikel, worin der Artikel ein geformter Artikel, ein thermogeformter Artikel, ein extrudierter Film, eine extrudierte Folie, eine oder mehrere Schichten eines mehrschichtigen Artikels, ein Substrat für einen beschichteten Artikel, oder ein Substrat für einen metallisierten Artikel, hergestellt aus dem Copolycarbonat oder der Zusammensetzung gemäß irgendeinem oder mehreren der Ansprüche 1 bis 11, ist.

13. Ein metallisierter Artikel umfassend das Copolycarbonat oder die Zusammensetzung gemäß irgendeinem oder mehreren der Ansprüche 1 bis 11, worin die Defekt-Anfangstemperatur des metallisierten Artikels innerhalb von 20 Grad Celsius der Hitzeverformungstemperatur des Copolycarbonats oder der Zusammensetzung liegt, gemessen flach an einem 80 x 10 x 4 mm Stab mit einer 64 mm Spanne bei 0,45 Mpa gemäß ISO 75/Bf.

14. Ein metallisierter Artikel, der Folgendes umfasst:
ein Substrat umfassend das Copolycarbonat oder die Zusammensetzung gemäß irgendeinem der Ansprüche 1 bis 11;
und
eine Metallschicht angeordnet auf mindestens einer Seite des Substrats.

15. Der Artikel gemäß Anspruch 14, weiter umfassend eine Schutzschicht angeordnet auf der Metallschicht.

## Revendications

1. Copolycarbonate comprenant des premiers motifs répétitifs, des deuxièmes motifs répétitifs différents des premiers motifs répétitifs, et des troisièmes motifs répétitifs différents des premiers et deuxièmes motifs répétitifs ; et dans lequel
les premiers motifs répétitifs sont des motifs carbonate de phtalimidine de formule 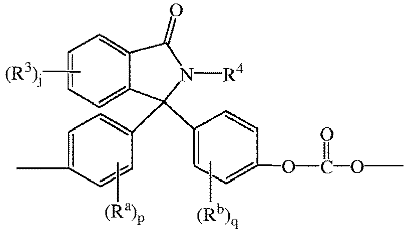 dans laquelle
chacun de R^{a} et R^{b} est indépendamment un alkyle en C₁ à C₁₂, alcényle en C₂ à C₁₂, cycloalkyle en C₃ à C₈, ou alcoxy en C₁ à C₁₂,
chaque R³ est indépendamment un alkyle en C₁ à C₆,
R⁴ est un hydrogène, alkyle en C₂ à C₆ ou phényle éventuellement substitué par 1 à 5 groupes alkyle en C₁ à C₆, chacun de p, q et j vaut indépendamment de 0 à 4,
les deuxièmes motifs répétitifs sont des motifs carbonate de formule 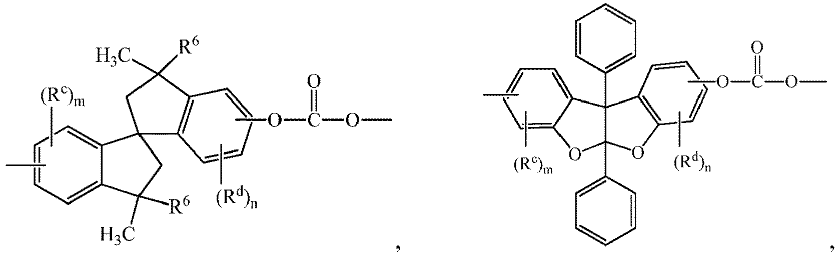 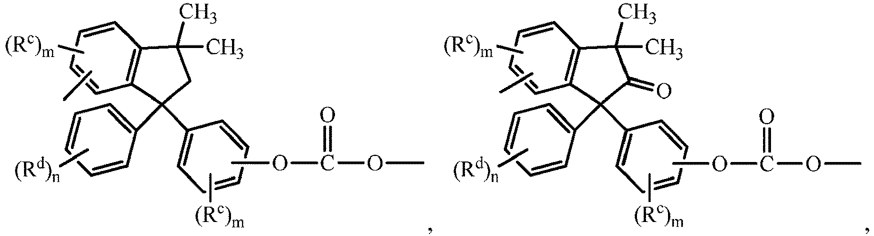 ou 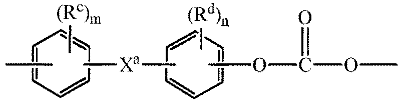 formules dans lesquelles
chacun de R^{c} et R^{d} est indépendamment un alkyle en C₁ à C₁₂, alcényle en C₂ à C₁₂, cycloalkyle en C₃ à C₈, ou alcoxy en C₁ à C₁₂,
chaque R⁶ est indépendamment un alkyle en C₁ à C₃ ou phényle ; X^{a} est un aryle polycyclique en C₆ à C₁₂, mono- ou polycycloalkylène en C₃ à C₁₈, mono- ou poly-cycloalkylidène en C₃ à C₁₈, un groupe -(Q¹)ₓ-G-(Q²)_{y}- dans lequel chacun de Q¹ et Q² est indépendamment un alkylène en C₁ à C₃, G est un cycloalkylène en C₃ à C₁₀, x vaut 0 ou 1, et y vaut 1 ; et
chacun de m et n vaut indépendamment de 0 à 4 ; et
les troisièmes motifs répétitifs sont des motifs carbonate de formule 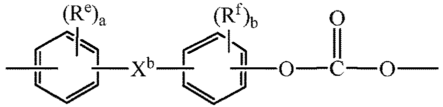 dans laquelle
chacun de R^{e} et R^{f} est indépendamment un alkyle en C₁ à C₁₂, alcényle en C₂ à C₁₂, cycloalkyle en C₃ à C₈, ou alcoxy en C₁ à C₁₂,
chacun de a et b est indépendamment un entier de 0 à 4, et
x^{b} est une liaison simple, -O-, -S-, -S(O)-, -S(O)₂-, -C(O)- ou un groupe hydrocarboné pontant en C₁ à C₃₂, sous réserve que X^{b} ne soit pas un groupe phtalimidine ou X^{a}.

2. Copolycarbonate selon la revendication 1, dans lequel les premiers motifs répétitifs sont des motifs carbonate de phtalimidine de formule 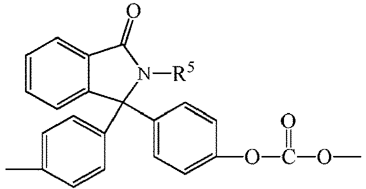 dans laquelle R⁵ est un phényle.

3. Copolycarbonate selon la revendication 1 ou 2, dans lequel les deuxièmes motifs répétitifs répondent à la formule structurelle 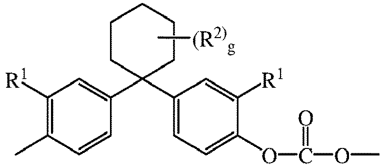 dans laquelle
chaque R¹ est indépendamment un hydrogène ou un alkyle en C₁ à C₄,
chaque R² est indépendamment un alkyle en C₁ à C₄ ou un hydrogène, et
g vaut de 0 à 10.

4. Copolycarbonate selon la revendication 3, dans lequel R¹ est un méthyle ou hydrogène, R² est un méthyle ou éthyle, et g vaut de 0 à 3.

5. Copolycarbonate selon l'une quelconque ou plusieurs des revendications 1 à 4, dans lequel les deuxièmes motifs répétitifs sont des motifs 1,1-bis(4-hydroxyphényl)-3,3,5-triméthylcyclohexanecarbonate.

6. Copolycarbonate selon la revendication 1 ou la revendication 2, dans lequel les deuxièmes motifs répétitifs sont des motifs carbonate de formule : 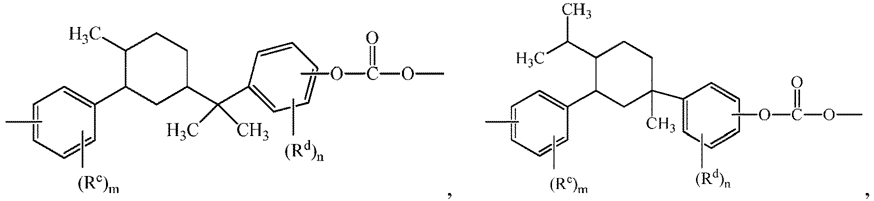 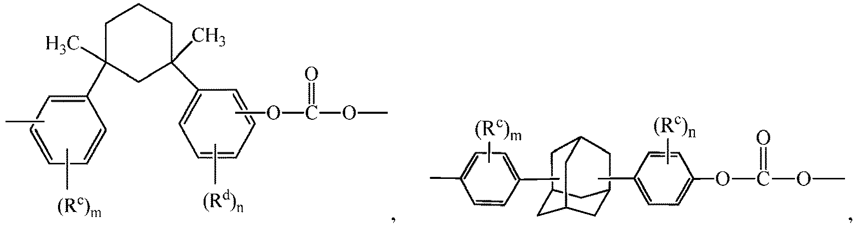 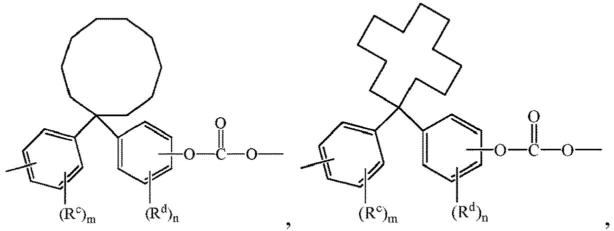 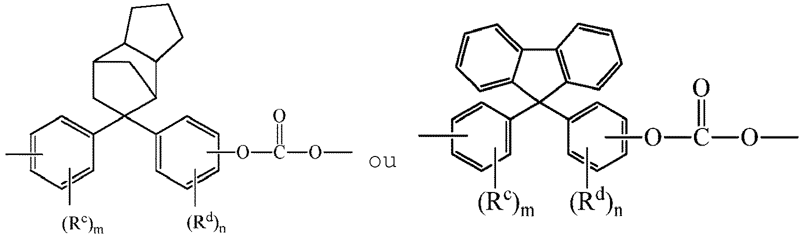 formules dans lesquelles
chacun de R^{c} et R^{d} est indépendamment un alkyle en C₁ à C₁₂, alcényle en C₁ à C₁₂, cycloalkyle en C₃ à C₈, ou alcoxy en C₁ à C₁₂ ; et
chacun de m et n vaut indépendamment de 0 à 4.

7. Copolycarbonate selon l'une quelconque ou plusieurs des revendications 1 à 6, dans lequel les troisièmes motifs répétitifs sont des motifs carbonate de bisphénol A.

8. Copolycarbonate selon l'une quelconque ou plusieurs des revendications 1 à 7, lequel copolycarbonate comprend 3 % en moles à 28 % en moles des premiers motifs répétitifs, 4 % en moles à 20 % en moles des deuxièmes motifs répétitifs, et 45 % en moles à 70 % en moles des troisièmes motifs répétitifs, chaque pourcentage étant basé sur la somme des moles des premiers motifs répétitifs, des deuxièmes motifs répétitifs, et des troisièmes motifs répétitifs.

9. Composition thermoplastique comprenant le copolycarbonate de l'une quelconque ou plusieurs des revendications 1 à 8.

10. Composition thermoplastique selon la revendication 9, comprenant en outre un homopolymère de polycarbonate, un poly(ester-carbonate), ou une de leurs combinaisons, éventuellement dans lequel l'homopolymère de polycarbonate est un homopolycarbonate de bisphénol A.

11. Composition thermoplastique selon la revendication 10, dans laquelle l'homopolymère de polycarbonate est présent en une quantité de 30 % en poids à 60 % en poids par rapport au poids total de la composition.

12. Article, lequel article est un article moulé, un article thermoformé, un film extrudé, une feuille extrudée, une ou plusieurs couches d'un article multicouche, un substrat pour un article revêtu, ou un substrat pour un article métallisé, fait à partir du copolycarbonate ou de la composition de l'une quelconque ou plusieurs des revendications 1 à 11.

13. Article métallisé comprenant le copolycarbonate ou la composition de l'une quelconque ou plusieurs des revendications 1 à 11, dans lequel la température d'apparition de défaut de l'article métallisé est , à 20 degrés Celsius près, la température de déformation à chaud du copolycarbonate ou de la composition, mesurée à plat sur une barre de 80 x 10 x 4 mm avec une portée de 64 mm sous 0,45 MPa conformément à la norme ISO 75/Bf.

14. Article métallisé comprenant :
un substrat comprenant le copolycarbonate ou la composition de l'une quelconque des revendications 1 à 11 ; et
une couche métallique disposée sur au moins un côté du substrat.

15. Article selon la revendication 14, comprenant en outre une couche protectrice disposée sur la couche métallique.
